(19) **Europäisches Patentamt / European Patent Office / Office européen des brevets**

(11) **EP 3 576 292 B1**

(12) **EUROPEAN PATENT SPECIFICATION**

(45) Date of publication and mention
of the grant of the patent:
**10.01.2024 Bulletin 2024/02**

(21) Application number: **18744535.8**

(22) Date of filing: **18.01.2018**

(51) International Patent Classification (IPC):
**H02P 21/14** *(2016.01)*    **H02P 23/06** *(2016.01)*
**G01R 31/34** *(2020.01)*    **G01R 22/06** *(2006.01)*

(52) Cooperative Patent Classification (CPC):
**H02P 21/14; H02P 23/06;** G01R 31/343

(86) International application number:
**PCT/JP2018/001361**

(87) International publication number:
**WO 2018/139331 (02.08.2018 Gazette 2018/31)**

(54) **MOTOR POWER CONVERSION DEVICE, AND MOTOR POWER CONVERSION SYSTEM USING SAME**

VORRICHTUNG ZUR MOTORLEISTUNGSUMWANDLUNG UND DIESE VERWENDENDES SYSTEM ZUR MOTORLEISTUNGSUMWANDLUNG

DISPOSITIF DE CONVERSION DE PUISSANCE DE MOTEUR ET SYSTÈME CONVERSION DE PUISSANCE DE MOTEUR L'UTILISANT

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **24.01.2017   JP 2017010282**

(43) Date of publication of application:
**04.12.2019 Bulletin 2019/49**

(73) Proprietor: **Hitachi Industrial Equipment Systems Co., Ltd.**
**Chiyoda-ku**
**Tokyo 101-0022 (JP)**

(72) Inventors:
• **ITO Akira**
**Tokyo 101-0022 (JP)**

• **AOYAMA Tomoyuki**
**Tokyo 101-0022 (JP)**
• **KOBAYASHI Sumio**
**Narashino-shi**
**Chiba 275-0001 (JP)**

(74) Representative: **MERH-IP Matias Erny Reichl Hoffmann**
**Patentanwälte PartG mbB**
**Paul-Heyse-Strasse 29**
**80336 München (DE)**

(56) References cited:
EP-A1- 3 107 204      CN-A- 103 523 010
JP-A- H07 322 673     JP-A- 2014 003 751
US-A1- 2007 056 185   US-A1- 2016 020 721

**Description**

TECHNICAL FIELD

The present invention relates to a motor power conversion device, and more particularly to a motor power conversion device having a function of measuring efficiency of a motor.

BACKGROUND ART

In recent years, global environment protection such as global warming prevention and ozone layer protection has become a major issue. The energy used amount in the industrial field in Japan is said to be 50% or more of that in the whole country, and 70% of the power amount used in the average factory is said to be used by motors. With respect to induction type motors driven by a commercial power source, a standard for the efficiency value of the induction type motor has been established, and thus, high efficiency motors have been actively introduced.

High efficiency has also been achieved for AC servo motors and vector control inverter driven motors, and PM motors using permanent magnets for rotors have become mainstream from induction type motors.

In industrial fields such as semiconductors, electronic parts manufacturing/assembly machines, and forging machines, in speed, torque, and position control applications, permanent magnet type AC servo motors, DC brushless motors, and motors dedicated to vector control inverter driving are used for rapid acceleration/deceleration utilizing servo performance and positioning control. As an example of these applications, in the field of forging machines, a punching machine that performs high-speed continuous drilling of thin plates can operate at a hit rate of about 500 times/min, and a surface mounting machine which mounts electronic components on a printed circuit board performs high-speed mounting at a tact time for mounting chip parts of 0.18 seconds per chip. Therefore, these greatly contribute to the improvement of productivity in production facility for general industrial machines. These loads are not necessarily constant continuously applied loads, but these are repetitive load use where acceleration, deceleration, pushing, or holding with variable speeds, or servo lock and hovering are frequently repeated or repetitive load continuous use where these operations are continuously repeated.

These motors are different from induction type motors (referred to as general-purpose motors) driven by a general commercial power source. For a general-purpose motor before shipment from a factory, in a method of evaluating the motor efficiency, a simulated load device is connected to a motor output shaft, a load is applied to the simulated load device, the load of the simulated load device side is adjusted so that the torque of the general-purpose motor to be evaluated becomes a rated torque, after that, a temperature rising test is performed, after the temperature rising value of the coil of the general-purpose motor is saturated, an input power (W) of the motor is read with a power meter, and the output power (W) is obtained by multiplying (rated torque × rotation speed of the output shaft) by a proportional coefficient and calculating efficiency = (output power/input power) × 100 (%).

However, the AC servo motor used in repetitive load continuous use repeats the forward rotation operation and the reverse rotation operation at a high speed, and thus, it is clear that the efficiency value cannot be applied even if the efficiency data at a certain rated torque is obtained from the manufacturer. For this reason, there is an issue of how to consider the efficiency and how to reduce the power (output power) and the power consumption (input power) of the motor so as to save energy. Alternatively, when driving with the hit rate or tact time reduced to half, the power and power consumption can be reduced, but it is doubtful that energy saving can be achieved as the power amount, and conversely, the speed is decreased. Therefore, processing and mounting cannot be completed within the determined time, and productivity declines cannot be achieved, and the expected output cannot be obtained. Eventually, there is a problem that cost increases, such as increasing the number of workers and responding. For this reason, the user cannot determine the energy saving effect of repetitive load continuous use.

As a background art of the present technical field, there is JP 2012-14649 A (Patent Document 1). Patent Document 1 discloses a "numerical control device capable of calculating power loss or power efficiency from calculated or estimated values of output power or output energy of driving related components such as a converter, an inverter, and an amplifier and performing display, print output, recording output to a storage medium, and output to other devices". Furthermore, according to the disclosure, "during powering of a motor, the power loss of each driving related component can be obtained from a difference between the input power and the output power, and the power efficiency can be obtained by dividing the output power by the input power. In addition, during regeneration of the motor, the power loss can be obtained from a difference between the output power and the input power, and the power efficiency can be obtained by dividing the input power by the output power". In addition, "for example, in a case where the motor is stopped, the power efficiency is not updated, and in a case where the power efficiency is less than the minimum power efficiency, an alarm is displayed". In addition, according to the disclosure, "since the power loss or the power efficiency of the driving related component is known, it can be clearly recognized in which driving related component in the machine tool the power loss is large or the power efficiency is not good. Therefore, it is easy to improve the power efficiency".

CITATION LIST

PATENT DOCUMENT

      Patent Document 1: JP 2012-14649 A
      Patent Document 2: EP 3 107 204 A1
      Patent Document 3: US 2016/020721 A1
      Patent Document 4: US 2007/056185 A1

SUMMARY OF THE INVENTION

PROBLEMS TO BE SOLVED BY THE INVENTION

In Patent Document 1, the calculated power loss or power efficiency is merely one of the power loss/efficiency data obtained from the rotation speed or the torque of the motor at the instantaneous timing measured in repetitive load use of operating at a high speed or in repetitive load continuous use, but the calculated power loss or power efficiency is not the accurate motor loss power amount or motor average efficiency which represents the whole operations. For this reason, it is difficult to improve the motor loss power amount and the motor average efficiency. In Patent Document 2, total loss, which in addition to copper loss includes iron loss, quantitatively difficult-to-predict stray load loss and mechanical loss, is calculated. A motor power conversion device is realized with an overload protection electronic thermal relay which detects by constantly performing said calculation with the motor in four-quadrant operation, and operates at a fixed product of time and total loss. Patent Document 3 discloses a motor control device including a power-consumption calculation unit that calculates a power loss and a motor output from a product of the motor velocity and a torque or thrust force, depending on whether a regenerative resistance is in an energized state. Patent Document 4 shows an energy management apparatus managing energy consumption of a machine, which has a supply part for supplying energy and a consume part for consuming the energy supplied by the supply part, so that the energy consumed by the consume part is positively saved. An operating part operates the consume part by using the energy supplied by the supply part. An acquisition part acquires an energy conversion characteristic, as an energy efficiency, from an input energy supplied to the consume part into an output energy output from the consume part. A change part changes an operating condition of the consume part based on the acquired energy efficiency so as to manage an actual value of the energy efficiency.

In addition, according to Patent Document 1, in a case where the input power becomes equal to or less than a predetermined minimum input power, the efficiency calculation condition is determined not to be satisfied, and thus, although the power efficiency is not updated, and the power loss becomes zero, there is no problem, so that it is considered that there is no need to perform special calculations. However, in machine tools, there actually occurs servo lock in which the current position against external force is retained, hovering in which the current position on a vertical axis subject to gravity is retained, motor zero speed control or current position retaining control that occurs during the normal operation, or zero efficiency of the operation during holding and tightening of screw. Therefore, there is a need to measure the minimum input power down to zero and output the value to the outside.

In view of the above circumstances, the present invention is to provide a motor power conversion device capable of accurately calculating a motor average efficiency and a motor loss power amount even in repetitive load use by a motor and a motor power conversion system using the same.

SOLUTIONS TO PROBLEMS

In order to solve the above problems, the invention is set out in the appended set of claims.

EFFECTS OF THE INVENTION

According to the present invention, it is possible to provide a motor power conversion device capable of accurately calculating a motor average efficiency and a motor loss power amount in a repetitive load driving operation of a motor and a motor power conversion system using the same.

BRIEF DESCRIPTION OF THE DRAWINGS

Fig. 1 is a diagram illustrating a configuration of an average efficiency/loss calculation circuit in an embodiment.

Fig. 2 is a diagram illustrating a timing chart of output power from a motor rotation speed and torque in repetitive load use in the embodiment.

Fig. 3 is a diagram illustrating the timing chart of Fig. 2 as a locus of driving on rotation speed-torque coordinates.

Fig. 4 is a diagram illustrating a flow of power, input power and output power of a motor, and motor loss during powering in the embodiment.

Fig. 5 is a diagram illustrating a flow of power, input power and output power of the motor, and motor loss during regeneration in the embodiment.

Fig. 6 is a diagram illustrating an overall configuration in which a motor power conversion device in the embodiment is applied to a permanent magnet type motor.

Fig. 7 is a schematic diagram illustrating a configuration example of an input power detection circuit of a motor in the embodiment.

Fig. 8 is a diagram illustrating a static frictional torque in the embodiment.

Fig. 9 is a diagram illustrating a boundary region between the powering and the regeneration at the time of switching from the powering to the regeneration in the embodiment.

Fig. 10 is a diagram illustrating a boundary region between the powering and the regeneration at the time of switching from the regeneration to the powering in the embodiment.

Fig. 11 is a timing chart illustrating operations of Fig. 1.

Fig. 12 is a diagram illustrating an example in which the average efficiency/loss calculation circuit in the embodiment is implemented with another configuration.

Fig. 13 is a configuration diagram illustrating a motor efficiency measurement method in the embodiment.

Fig. 14 is a configuration diagram in which an efficiency/loss measurement command circuit is added to the overall configuration diagram of the motor power conversion device of Fig. 6 in the embodiment.

Fig. 15 is a diagram illustrating a timing chart of motor average efficiency measurement in forward and reverse powering and regeneration driving in the embodiment.

Fig. 16 is a diagram illustrating integration of an upstream-side power and a downstream-side power on rotation speed-torque coordinates in the timing chart of Fig. 15.

Fig. 17 is a diagram illustrating a relationship between reduction of an inertia momentum (motor + load) and input and output power amounts in the embodiment.

Fig. 18 is a diagram illustrating another configuration of the average efficiency/loss calculation circuit in the embodiment.

Fig. 19 is a diagram illustrating another overall configuration in which the motor power conversion device in the embodiment is applied to a permanent magnet type motor.

Fig. 20 is a configuration diagram illustrating a motor efficiency measurement method in the related art.

Fig. 21 is a diagram illustrating a motor efficiency measurement point on rotation speed-torque coordinates in the related art.

MODE FOR CARRYING OUT THE INVENTION

Hereinafter, embodiments of the present invention will be described with reference to the drawings.

First Embodiment

First, a relational expression of power of a motor according to the present embodiment will be described. Irrespective of an induction type motor or a permanent magnet type motor, an AC motor has a function of converting electrical energy into energy for work. However, input power Pin input to the AC motor does not all serve as the energy for work, and a portion of the input power is consumed as a loss inside the motor, which results in heat, or another portion of the input power results in sound. The power useful for work is output power Pout, which provided a torque Tf and a rotation speed Nf to a load connected to the motor. The input power and the output power are expressed in units of W (watts).

In addition, herein, a case where the direction in which the power flows from the power supply side to the load side is set to a positive value, and this case is called powering. Vice versa, a case where the direction in which the power flows from the load side to the power supply side is set to a negative value, and this case is called regeneration. The input power Pin (W) of the motor and the output power Pout (W) of the motor are represented by a positive or negative value.

When the motor is in the powering state, the motor efficiency ηm during the powering is expressed by Formula (1).

$$\eta m = (Pout/Pin) \times 100 \ (\%) \ ... \ (1)$$

In addition, in a case where the same measurement point as that in the powering state is expressed as the input power Pin (W) and the output power Pout (W) of the same symbols, when the motor is in the regeneration state, the motor efficiency ηg during the regeneration is expressed by Formula (2).

$$\eta g = (Pin/Pout) \times 100 \ (\%) \ ... \ (2)$$

Next, motor loss power Ploss (W) can be represented by Formula (3) irrespective of the powering and the regeneration.

$$Ploss = Pin-Pout \ (W) \ ... \ (3)$$

The physical quantity on which the heat quantity of a motor is based is not a motor current but a total loss Ploss of the motor. Although calculating the total loss by accumulating each loss requires ideas and labors, the total loss can be obtained even if the details of the loss are not known. That is, as expressed in Formula (3), the total loss Ploss of the motor can be obtained by subtracting the output power Pout from the input power Pin of the motor.

In addition, the motor output power Pout can be obtained by Formula (4).

$$Pout = (2\pi/60) \times Nf \times Tf \ (W) \ ... \ (4)$$

Herein, Nf: a rotation speed (1/min) of the motor
Tf: a torque (N·m) of the motor
In addition, $(2\pi/60 = 0.1047)$

Herein, the rotation speed Nf and torque Tf of the motor are quantities controlled by an AC servo amplifier or DCBL controller, an inverter, and a vector control inverter (these are collectively referred to as motor power conversion devices) for driving the motor and can be easily calculated in these motor power conversion devices. In addition, in the inverter, even if the motor does not have a speed sensor such as an encoder, sensorless vector control is performed to estimate a rotation speed of the motor and suppress a load fluctuation rate to a small value, so that speed control with high accuracy is performed. The motor output power Pout can also be calculated by using the estimated rotation speed Nf of the motor internally processed by this sensorless vector control inverter.

Herein, the AC motor has an axis at a cylindrical center, and the AC motor is not limited only to an induction type motor or a permanent magnet type motor that rotates this axis. The AC motor may be a linear motor in which the circumferential one portion of the AC motor on the stator side is cut open to be straight and the rotating portion is allowed to be linearly reciprocated. The AC servo amplifier, the DCBL controller, the inverter, or the vector control inverter for driving the linear motor can also drive the linear motor as it is. The linear motor driven by the AC servo amplifier is also called a linear servo motor. Hereinafter, the AC motor includes the linear motor even if not described.

In addition, the torque Tf of the AC motor can be expressed by torque Tf = F × r (N·m), where r is the radius to the outer periphery of the rotating body and F (N) is the force acting tangentially to the point of the radius r. Herein, Tf = F × r (N·m) is substituted into Formula (4), the moving speed vl (of the moving body) of the linear motor is represented by vl = (2π × r) × Nf/60, and the driving force of the linear motor is represented by F. Then, the output power Pout of the linear motor can be calculated by Pout = (F × vl)/60 (W). In the AC servo amplifier, the radius r is stored as an intrinsic constant for each model as conversion constants of a rotary motor and a linear motor, and the output power Pout of the linear motor can be calculated from the driving force F (N) and the moving speed vl.

Next, the motor input power Pin is obtained by calculating the product of instantaneous values of phase voltages and phase currents applied to the motor and the sum of phase powers of the U, V, and W phases of the motor by using Formula (5).

$$Pin = Vu·Iu + Vv·Iv + Vw·Iw \ (W) \ ... \ (5)$$

Herein, instantaneous values of the phase voltages are represented by Vu, Vv, and Vw, effective values of the phase voltage are represented by Vrms, an angular frequency of the power supply is represented by ω, and a time is represented by t. More specifically, the following Formulas (6-1) to (6-3) and (7-1) to (7-3) are substituted into Formula (5) and calculation is performed, so that the input power Pin of the motor can be obtained by Formula (8). That is,

$$Vu = \sqrt{2} \cdot Vrms \cdot \sin(\omega t) \ (V) \ \dots \ (6-1)$$

$$Vv = \sqrt{2} \cdot Vrms \cdot \sin(\omega t + 2\pi/3) \ (V) \ \dots \ (6-2)$$

$$Vw = \sqrt{2} \cdot Vrms \cdot \sin(\omega t + 4\pi/3) \ (V) \ \dots \ (6-3).$$

In addition, instantaneous values of the phase currents is represented by Iu, Iv, and Iw, an effective value of the phase currents is represented by Irms, and a phase angle is represented by $\phi$.

$$Iu = \sqrt{2} \cdot Irms \cdot \sin(\omega t + \phi) \ (A) \ \dots \ (7-1)$$

$$Iv = \sqrt{2} \cdot Irms \cdot \sin(\omega t + 2\pi/3 + \phi) \ (A) \ \dots \ (7-2)$$

$$Iw = \sqrt{2} \cdot Irms \cdot \sin(\omega t + 4\pi/3 + \phi) \ (A) \ \dots \ (7-3)$$

The input power Pin of the motor is expressed by Formula (8).

$$Pin = 3 \cdot Vrms \cdot Irms \cdot \cos\phi \ (W) \ \dots \ (8)$$

In addition, as another method, since the motor input power Pin is the outputs of these motor power conversion devices as described above and is an amount controlled by itself, so that the motor input power Pin can be easily calculated from Formula (9).

$$Pin = \sqrt{3} \times V \times I \times \cos\theta \ (W)$$
$$= 3 \times Vs \times I \times \cos\theta \ (W) \ \dots \ (9)$$

Herein, V: a line voltage (V) of the motor
Vs: a phase voltage of the motor (V)
I: a current (A) of the motor
$\cos\theta$: a power factor

Examples will be described below with reference to the drawings.

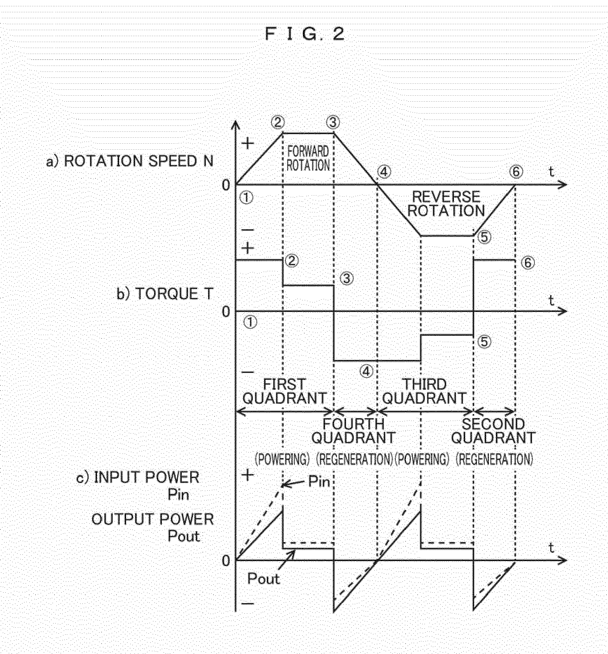

Fig. 2 is a diagram illustrating a timing chart of motor rotation speed, torque, output power, and the like in repetitive load use. (a) illustrates the rotation speed N of the motor, (b) illustrates the torque T, and (c) illustrates the input power Pin of the motor and the output power Pout for one cycle in repetitive load use. In (a), the rotation speed is forward-rotation-accelerated from zero to reach a constant speed. After that, the rotation speed is regeneratively decelerated to pass through zero speed, and is reverserotation-accelerated to reach a constant speed. After that, the rotation speed is regeneratively decelerated to return to zero speed. With respect to the rotation speed and the torque, forward rotation and reverse rotation or positive side torque and negative side torque are treated with positive and negative signs. Herein, in the case of a hit rate of 500 times/min, one cycle is 120 ms, and in the case of continuous operation, this is repeated. The motor output power Pout in Fig. 2 (c) is calculated by multiplying the rotation speed N in (a) of Fig. 2 and the torque T in (b) of Fig. 2 with a sign according to Formula (4). Since the sign of multiplication N × T in the forward rotation deceleration and the reverse rotation deceleration is negative, the output power is in the regeneration state, and thus, the motor is in the generator state. For this reason, the motor power flows from the load side to the power supply side.

In addition, since the output power outside the deceleration area is positive in sign, the powering state is established, and the motor is in a motor state. In this case, the motor power flows from the power supply side to the load side. Next, since the input power Pin of the motor is Pin > Pout because there is a loss of the motor during the powering, the Pin illustrated by a broken line in Fig. 2 (c) is illustrated to be larger than the Pout. During the regeneration, since the power flows from the load side to the power source, |Pin| < |Pout| when compared in absolute value, and thus, in terms of the magnitude, |Pin| becomes smaller.

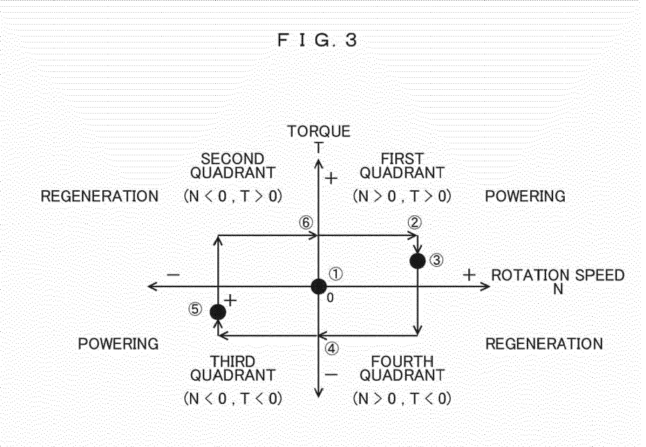

Fig. 3 is a diagram illustrating the timing chart of Fig. 2 as a locus of driving on the rotation speed-torque coordinates. In the figure, the rotation speed N is assigned to the x-axis, and the torque T is assigned to the y-axis. In the figure, the numbers (1) to (6) are attached, and in the timing chart of Fig. 2, the numbers of (1) to (6) are also attached to the rotation speed N and the torque T. The operations in the timing chart of Fig. 2 are drawn as a locus of driving on the coordinates. In the timing chart of Fig. 2, the locus rises vertically from the origin (1) of the rectangular coordinates, then goes horizontally toward (2) and circulates clockwise as (3), (4), (5), and (6). The rectangular coordinates are divided into four quadrants. The first quadrant and the third quadrant are motor operations in the powering area, and the second quadrant and the fourth quadrant are generator operations in the regeneration area. In addition, in Fig. 3, it is possible to move only the first quadrant and the fourth quadrant with N = 0 as the period in which the rotation speed N is N < 0.

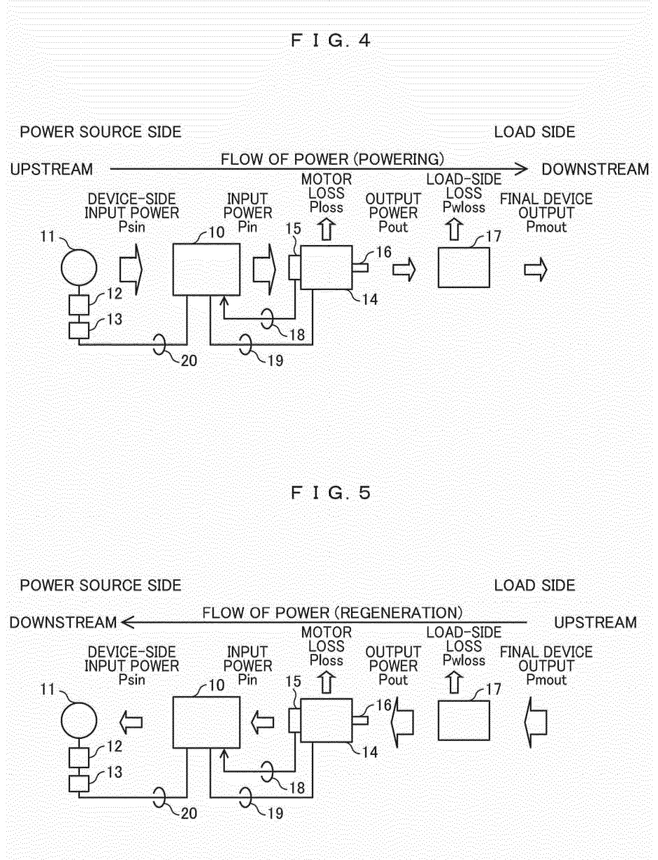

Fig. 4 is a diagram illustrating the flow of power during the powering, input power and output power of the motor, and motor loss. Reference numeral 14 denotes an AC motor, and the power supplied from an AC power supply 11 is connected to a motor power conversion device 10 through a power supply power cable 20 via a leakage circuit breaker 12 and an electromagnetic contactor 13. A motor drive cable 19 is connected from the motor power conversion device 10 to the AC motor 14. An encoder 15 is incorporated in the AC motor 14, and rotational position information is fed back to the motor power conversion device 10 by an encoder cable 18. A motor output shaft 16 is connected to various machines 17 which are loads of the motor, and the power of the AC motor 14 is transmitted to the various machines 17. Herein, when the device-side input power of the motor power conversion device 10 is represented by Psin, the input power of the AC motor 14 is represented by Pin, and the output power is represented by Pout, the motor efficiency $\eta$m becomes (Pout/Pin) $\times$ 100 (%) according to Formula (1). Next, the motor loss Ploss becomes Pin-Pout according to Formula (3). At this time, the flow of power is directed from the power supply side to the load side, the power supply side becomes the upstream, and the load side becomes the downstream.

Fig. 5 is a diagram illustrating the flow of power during the regeneration, input power and output power of the motor, and motor loss. The motor efficiency $\eta$g becomes (Pin/Pout) $\times$ 100 (%) according to Formula (2). The motor loss Ploss is expressed by Formula (3), but during the regeneration, as illustrated in (c) of Fig. 2, Pin < 0 and Pout < 0, and in absolute value, |Pin| < |Pout|. Therefore, Ploss = Pin-Pout = |Pout| - |Pin|. In signed calculation processing, the Pin-Pout may be calculated irrespective of the powering and the regeneration. At this time, the flow of power is directed from the load side to the power supply side, the load side becomes the upstream, and the power supply side becomes the downstream.

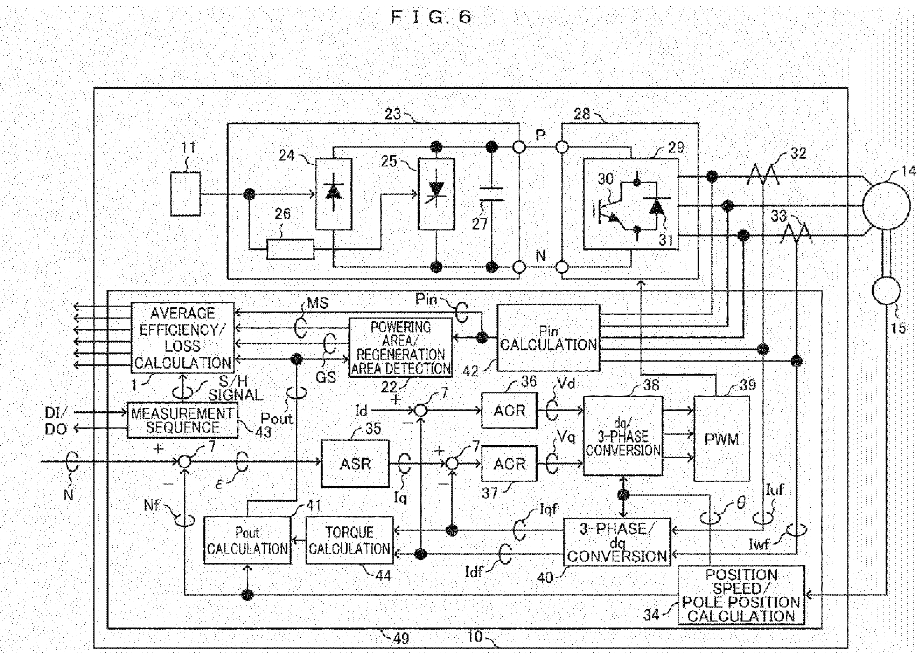

Fig. 6 is a diagram illustrating an overall configuration in which the motor power conversion device according to the present embodiment is applied to a permanent magnet type motor. The motor power conversion device 10 includes an AC servo amplifier, a DCBL controller, an inverter, and a vector control inverter. The main circuit is configured with a forward converter 23 with a power source regeneration function, an inverse converter 28, and U-phase and W-phase current detectors CTu 32 and CTw 33. The inverse converter 28 constitutes a multiphase inverter 29, and the figure illustrates a case of three phases. The permanent magnet type motor 14 is provided with an encoder 15 for position/speed/magnetic pole position detection on the motor shaft. Herein, in a case where the permanent magnet type motor is a linear motor, instead of the encoder 15, a linear sensor scale is placed on the fixed portion, and a linear sensor head is placed on the moving portion so as to be relatively close to the movement, so that the position and the speed are detected. In addition, in a case where a magnetic pole position detection signal for the magnet is required, a magnetic pole position detection sensor is separately attached. Hereinafter, it is assumed that the encoder includes a linear sensor in the case of a linear motor even if not described.

In addition, in a case where the motor power conversion device 10 is a DCBL controller or an inverter, the encoder 15 is not an essential component. This is because speed control can be performed by vector control even with a sensorless DCBL motor or a general-purpose motor. The magnetic pole position detection is for detecting the position of the magnetic pole of the permanent magnet attached to the rotor of the motor.

In the case of a motor with an encoder, the output of the encoder 15 attached to the motor shaft is transmitted to the position/speed/pole position calculator 34. The one is output to the rotation speed Nf of the motor, and the other one as the magnetic pole position signal $\theta$ is output to a dq/3-phase conversion circuit 38 and a 3-phase/dq conversion circuit 40. The rotation speed Nf is subtracted from the speed command N from the external calculation device (higher-level device) by a subtraction circuit 7, and the difference $\varepsilon$ (= N - Nf) is output and amplified by a speed controller (ASR) 35, so that a torque current command Iq is output.

The current of the permanent magnet type motor 14 is detected by the U-phase current detector CTu 32 and the W-phase current detector CTw 33 and is input to the 3-phase/dq conversion circuit 40 as current feedback Iuf and Iwf signals. In the 3-phase/dq conversion circuit 40, the 3-phase Iuf and Iwf signals are converted into Idf and Iqf signals represented by orthogonal d-axis and q-axis.

The torque current command Iq is output to the subtraction circuit 7 that calculates a difference from the torque current feedback signal Iqf, and the deviation is amplified by a q-axis current controller (ACR) 37. The d-axis current command Id is a current command in the case of performing field weakening, or the like. The difference with the d-axis current feedback signal Idf is taken by the subtraction circuit 7, and the deviation is amplified by the d-axis current controller (ACR) 36. The outputs of the d-axis and q-axis current controllers (ACR) 36 and 37 are input as d-axis and q-axis voltage commands Vd and Vq to the dq/3-phase conversion circuit 38, and the 3-phase voltage commands Vu, Vv, and Vw are output to a PWM circuit 39 and given as gate signals of the switching element 30 of the inverse converter 28, and thus, the permanent magnet type motor 14 is controlled.

Next, the output power calculation circuit 41 will be described. The motor current feedback Iuf and Iwf signals are converted into Idf and Iqf signals orthogonal to each other by the 3-phase/dq conversion circuit 40, and the vector calculation of the motor torque Tf is performed by the torque calculation circuit 44. The torque signal Tf and the rotation speed Nf output from the position/speed/pole position calculator 34 are input, and the output power calculation circuit 41 calculates Formula (4) to obtain an output power Pout.

Next, a powering area/regeneration area detection circuit 22 which is a portion of the present embodiment will be described. The powering area/regeneration area detection circuit 22 is operated from two inputs of Pin which is the output of the input power calculation circuit 42 and Pout which is the output of the output power calculation circuit 41. In Fig. 3, with respect to the four areas of the first to fourth quadrants in the N-T coordinates of the rotation speed N and the torque T, the first and third quadrants are described as the powering area, and the second and fourth quadrants described as the regeneration area. However, with respect to the boundary of the four quadrants of the rotation speed N and the torque T, under the assumption that the boundary region is determined by the output power Pout which is the product of the rotation speed N and the torque T in Formula (4), if only the positive and negative signs of the output power Pout are monitored, there are the following problems.

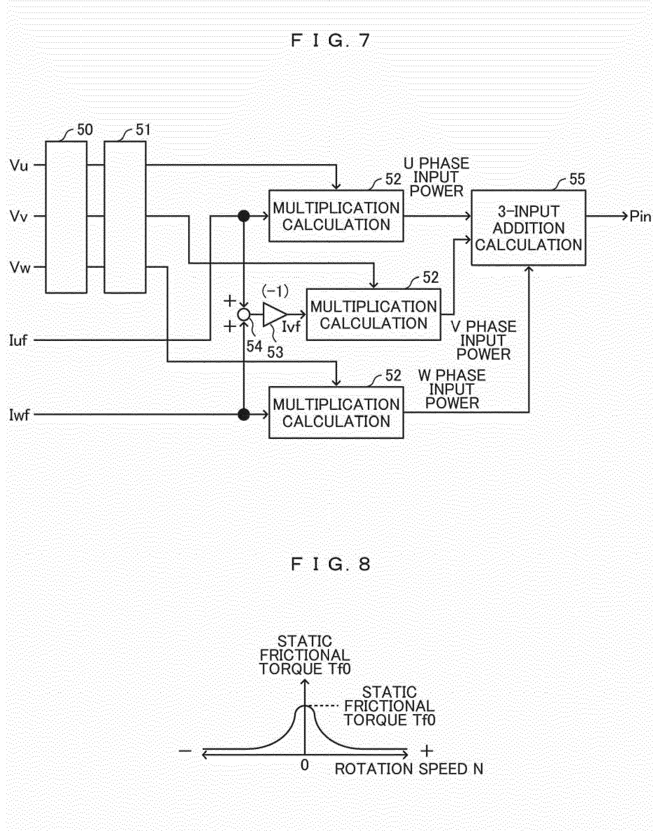

That is, the object of the present embodiment is to accurately obtain the efficiency of the motor by allowing the driving operation of the motor to include repetitive load which repeats the powering and the regeneration in the forward rotation and the reverse rotation. For this reason, in the two states of the flow of the power, that is, the powering directed from the power supply side to the load side and the regeneration directed from the load side to the power supply side, which is the opposite of the powering, in the fractional formula of Formulas (1) and (2) for the efficiency calculation, if the denominator becomes zero, a singular point where $\eta$m or $\eta$g is infinite is generated. The highest efficiency of the motor efficiency is 100%. There is a method of applying a limit so that it does not exceed 100% in numerical processing, but in that case, it may be processed only with the numerical value of the efficiency without correcting that the values of the input power Pin and the output power Pout are wrong. In order to avoid this problem, as the boundary condition of the powering and the regeneration, the time (at this time, the efficiency is zero) when the numerators of Formulas (1) and (2) become zero by taking care that the values of the denominators of Formulas (1) and (2) does not become zero is defined as the entrance of the boundary region. At the exit of the boundary region, at the time when the sign of the values of the numerators in Formulas (1) and (2) is inverted from zero (at this time, the efficiency is zero), and the increase is confirmed, it is confirmed that the sign of the denominator is inverted and the value is increased, the locus leaves the boundary region, and the movement to the new area is completed. By moving to the entrance and the exit of the boundary region in this procedure, the denominator and the numerator of the efficiency formula are replaced with each other, and thus, the efficiency at the entrance and the exit (efficiency according to the numerator of zero) is secured to be zero. Next, this boundary region will be described with reference to Figs. 8 to 10.

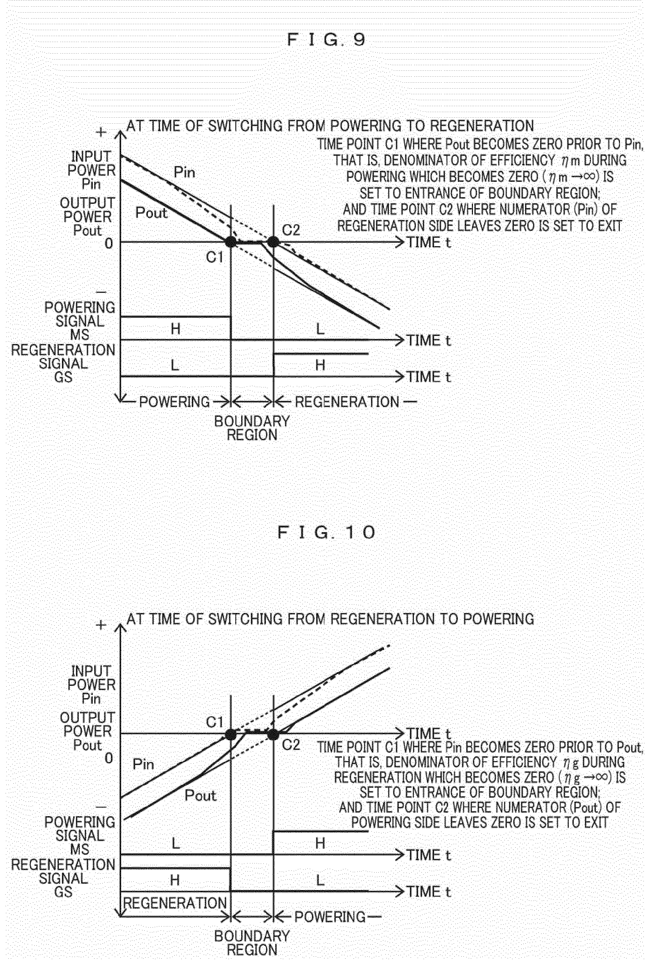

Fig. 8 is a diagram illustrating a static frictional torque. When objects move relative to each other while being into contact with each other, a force acts on the contact surface in a direction that impedes the movement. In addition, the same occurs when one of the objects moves while rolling on the contact surface. These forces are frictional forces, the former is called sliding friction, and the latter is called rolling friction. In addition, the magnitudes of the frictional force are different before and after the object starts moving, and when the object starts moving, the frictional force decreases. The frictional force before the object starts moving is called the static frictional force, and the frictional force after the object starts moving is called the dynamic frictional force. Fig. 8 illustrates the static frictional torque Tf0 measured as a motor torque at a rotation speed near zero. This is indicated as a general static frictional torque. The influence of this static frictional torque will be described in detail with reference to Figs. 9 and 10.

Fig. 9 is a diagram illustrating the boundary region between the powering and the regeneration at the time of switching from the powering to the regeneration. If the switching operation of Fig. 9 is applied to the four quadrant areas of Fig. 3, the switching operation is the operation of directing from the first quadrant to the fourth quadrant or the operation of directing from the third quadrant to the second quadrant. In Fig. 9, the x-axis is time, the y-axis is the input power Pin and the output power Pout, and the case of the transient state where the driving state of the motor is switched from the powering area to the regeneration area is illustrated. In the first powering state, the input power Pin is large, and the output power Pout is small. Parallel lines of the input power Pin and the output power Pout are drawn as a reference. However, on this line, the Pin described herein is indicated by a broken line, and the Pout is indicated by a solid line.

In addition, the lower portion of the figure illustrates the powering, the regeneration, and the boundary region between the powering and the regeneration, and the logic of the powering signal MS and the regeneration signal GS output from the powering area/regeneration area detection circuit 22 illustrated in Fig. 6 to the average efficiency/loss calculation circuit 1 is illustrated. The MS signal is at the H level when the motor is in the powering, the GS signal is at the H level when the motor is in the regeneration, and the MS signal and GS signal are at the L level otherwise. In the boundary region between the powering and the regeneration, both of the MS and GS signals are at the L level.

As a boundary condition from the powering area to the regeneration area, the value of the denominator (Pin) in Formula (1) gradually decreases from the reference line and gradually approaches zero. However, the time point when the numerator (Pout) first becomes zero (C1 in the figure, at which point the efficiency is zero) is the entrance of the boundary region. When the Pout becomes zero, the Pin suddenly goes to zero, and thus, the Pin and the Pout once become zero, so that the flow of power is interrupted. At the exit of the boundary region, at the time when the sign of the value of the numerator (Pin) in Formula (2) is inverted from zero (C2 in the figure, at which point the efficiency is zero), and the increase is confirmed, it is confirmed that the sign of the denominator (Pout) is inverted and the value is increased, and the locus leaves the boundary region.

When being directed to the boundary region, the Pin and the Pout grow rapidly, and the movement to the new regeneration area is completed along the reference line. In addition, in the motor control, since the rotation speed N and the torque T are controlled, the output power Pout operates in advance, and the input power Pin follows the movement of the output power Pout. As described above, at the time of switching from the powering to the regeneration, the output power Pout on the numerator side during the powering passes through zero to become the entrance of the boundary region, and the input power Pin on the numerator side during the regeneration rises from zero to become the exit of the boundary region, so that there occur no singular point at which the denominator of the efficiency calculation formula becomes zero.

Fig. 10 is a diagram illustrating the boundary region between the powering and the regeneration at the time of switching from the regeneration to the powering. If the switching operation of Fig. 10 is applied to the four quadrant areas of Fig. 3, the switching operation is the operation of directing from the fourth quadrant to the third quadrant or operation of directing from the second quadrant to the first quadrant. In Fig. 10, the x-axis is time, the y-axis is the input power Pin and the output power Pout, and the case of the transition state where the driving state of the motor is switched from the regeneration area to the powering area. In the first regeneration state, the absolute value of the output power Pout is large, and the absolute value of the input power Pin is small. Parallel lines of the input power Pin and the output power Pout are drawn as a reference. However, on this line, the Pin described herein is indicated by a broken line, and the Pout is indicated by a solid line.

In addition, the lower portion of the figure illustrates the powering, the regeneration, and the boundary region between the powering and the regeneration, and the logic of the powering signal MS and the regeneration signal GS output from the powering area/regeneration area detection circuit 22 illustrated in Fig. 6 to the average efficiency/loss calculation circuit 1 is illustrated. The logic has been described in Fig. 9, and thus, the description thereof is omitted.

As a boundary condition from the regeneration area to the powering area, the value of the denominator (Pout) in Formula (2) gradually decreases from the reference line and gradually approaches zero. However, the time point when the numerator (Pin) first becomes zero (C1 in the figure, at which point the efficiency is zero) is the entrance of the boundary region. When the Pin becomes zero, the Pout suddenly goes to zero, and thus, the Pin and the Pout once become zero, so that the flow of power is interrupted. At the exit of the boundary region, at the time when the sign of the value of the numerator (Pout) in Formula (1) is inverted from zero (C2 in the figure, at which point the efficiency is zero), and the increase is confirmed, it is confirmed that the sign of the denominator (Pin) is inverted and the value is increased, and the locus leaves the boundary region.

In addition, herein, in a case where the switching operation in Fig. 10 is the operation of directing from the fourth quadrant to the third quadrant in Fig. 3 or the operation of directing from the second quadrant to the first quadrant in Fig. 3, if the speed passes from the forward rotation through zero to the reverse rotation, the torque exceeds the static frictional torque illustrated in Fig. 8. At that time, due to fluctuations in load torque, the input power Pin and the output power Pout grow rapidly while fluctuating as if external disturbance is applied, and the movement to the new powering area is completed along the reference line. As described above, at the time of switching from the regeneration to the powering, the input power Pin on the numerator side during the regeneration passes through zero to become the entrance of the boundary region, and the output power Pout on the numerator side during the powering rises from zero to become the exit of the boundary region, so that there occur no singular point at which the denominator of the efficiency calculation formula becomes zero.

From the above-described Figs. 9 and 10, in the boundary region between the powering and the regeneration, the point where both the input power Pin and the output power Pout become zero is monitored, and when passing from the powering to the regeneration or from the regeneration to the powering, no singular point occurs between these two points when the calculation is performed in the boundary region with zero efficiency. The powering, the regeneration, and the boundary region between the powering and the regeneration are detected by the powering area/regeneration area detection circuit 22 illustrated in Fig. 6 and are output to the average efficiency/loss calculation circuit 1 by the powering signal MS and the regeneration signal GS.

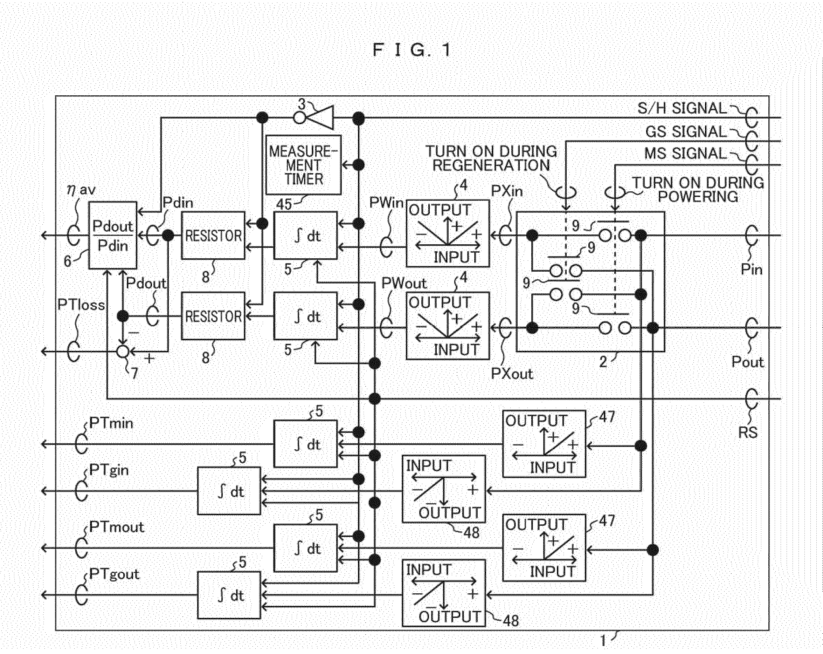

In addition, the average efficiency/loss calculation circuit 1 which is a portion of the present embodiment will be described in detail later with reference to Fig. 1, and the measurement sequence circuit 43 will be described herein. The measurement sequence circuit 43 can input the measurement start timing and the measurement end timing for instructing the operation period for measuring the motor average efficiency and the motor loss power amount in the average efficiency/loss calculation circuit 1 to the average efficiency/loss calculation circuit 1 at the input timing of the DI/DO signal from the external calculation device (higher level device).

In addition, the measurement sequence circuit 43 is allowed to be able to set parameters so as to start measurement in synchronization with the ON of the SON signal for performing servo start and stop of the general-purpose I/O of the motor power conversion device 10, to end measurement in synchronization with the OFF of the SON signal, and to output the calculation result after the end of the OFF of the SON signal. According to this function, even in a speed zero state such as servo lock control of starting servo (SON signal is ON)) which is generally used as a function of servo, starting servo position and speed control, and retaining and controlling a current position, hovering operation of retaining a current position on a vertical axis in which gravity is exerted, and an screw tightening operation of continuing to tighten a bolt by the time when the speed is zero by a P (proportional) control operation according to a certain speed command, it is possible to measure the motor average efficiency and the loss power amount. The speed zero state is a state where the motor output power is zero and only a loss occurs in terms of the motor efficiency. However, since there is room for improvement such as appropriately completing screw tightening in a short time and minimizing the loss. It is important to update and display the efficiency zero data of the motor efficiency measurement result and output the data to an external calculation device (higher-level device).

The speed controller (ASR) 35, the d-axis and q-axis current controllers (ACR) 36 and 37, the PWM circuit 39 (different block diagrams), the average efficiency/loss calculation circuit 1, and the measurement sequence circuit 43 in the control logic circuit 49 described above are realized by cooperation of an calculation device such as a CPU or a DSP and software. For this reason, the "circuit" described in the present embodiment has the same meaning as the "processing unit" performed by software processing and may be read and replaced by the "processing unit".

Fig. 7 is a schematic diagram illustrating a configuration example of the input power calculation circuit 42 of the motor in the present embodiment. In this example, phase voltages Vu, Vv, and Vw are input from the terminal voltages of the motor, and the phase voltage signal is detected through the filter circuit 50 and the insulation amplifier 51. In addition, the motor current is detected as Iuf and Iwf from the U-phase and W-phase current detectors CTu32 and CTw33. Specifically, the phase current Ivf is configured to be Ivf = -(Iuf + Iwf) from the 3-phase current Iuf + Ivf + Iwf = 0. The CPU of the control logic circuit 49 performs the product operation of the phase voltage of Formulas (6-1) to (6-3) and the phase current of Formulas (7-1) to (7-3) by calculating the instantaneous value product of the phase voltage and the phase current for each of U, V and W phases according to the calculation of Formula (5). As a result, the CPU obtains the "3-phase input power Pin" by adding the U-phase, V-phase, and W-phase input powers of the respective phases. In addition, the calculation of Pout and Pin is not limited to the examples of Figs. 6 and 7 described above. Heretofore, the whole outline of the peripheral portions of the present embodiment is described.

Fig. 1 is a diagram illustrating the configuration of the average efficiency/loss calculation circuit 1 in the present embodiment. In addition, Fig. 1 is a detailed diagram of the average efficiency/loss calculation circuit 1 illustrated in Fig. 6.

First, the input signal will be described. A signal indicating the input power data of the motor is denoted by Pin, and a signal indicating the output power data of the motor is denoted by Pout. Data are input from the input power calculation circuit 42 and the output power calculation circuit 41 in a certain cycle.

In addition, for an operation of one process, a period for measuring the motor average efficiency and the loss amount is input as an S/H signal. The measurement starts at the rising edge of the S/H signal, and the measurement stops at the falling edge of the S/H signal. The S/H signal is input from the external input/output DI/DO signal via the measurement sequence circuit 43.

With respect to the powering signal MS and the regeneration signal GS, the MS signal of H indicates that the motor is during the powering, the GS signal of H indicates that the motor is during regeneration, and both the MS signal and GS signal of L indicates that the motor is in the boundary region between the powering and the regeneration. The MS signal and the GS signal are output from the powering area/regeneration area detection circuit 22.

The reset input RS is a reset signal controlled at a required timing from the CPU or the DSP mounted on the control logic circuit 49. In addition, in Fig. 6, the reset signal is omitted because Fig. 6 is a block diagram illustrating the entire configuration of the periphery in the present embodiment.

Next, the output signal will be described. The motor average efficiency data ηav is output as the data of the motor average efficiency within an operation period of one process after the motor efficiency calculation processing after measurement is stopped at the falling edge of the S/H signal.

Similarly to ηav, the motor loss power amount PTloss is the data of the motor loss power amount within an operation period of one process and is output at the same timing as ηav.

In addition, with respect to the four signals of PTmin, PTgin, PTmout, and PTgout, as the data output of the motor input power amount and the motor output power amount for the powering and the regeneration within an operation period of one process, PTmin is the data output of the total power amount during the powering of the input power Pin, and PTgin are data outputs of the total power amount during the regeneration of the input power Pin. PTmout is the total power amount during the powering of the output power Pout. PTgout is the data output of the total power amount during the regeneration of the output power Pout. These are the data output after the calculation process of the motor input power amount and the motor output power amount after stopping the measurement at the falling edge of the S/H signal.

The efficiency formula during the powering and the efficiency formula during the regeneration have been described by Formulas (1) and (2). In the present embodiment, the motor handles repetitive load use or repetitive load continuous use where the powering and the regeneration are frequently repeated. Herein, it is not preferable that, every time the input power and the output power are detected in a certain cycle, a division processing operation is performed from the motor efficiency formulas (1) or (2), and the motor efficiency average value is calculated from these motor efficiency data groups after the completion of the measurement, because it takes time for the calculation processing. In particular, it is a division processing operation in progress in real time within a period input by the measurement start/stop signal S/H. In addition, although the motor loss power is expressed by Formula (3), the load factor of the CPU or the DSP can be reduced if the motor loss power is obtained by using the data calculated in the process for calculating the motor average efficiency.

In the present embodiment, after the measurement start/stop signal S/H ends, the processing procedure is devised as follows to calculate the motor average efficiency in one process after the division process for calculating the motor efficiency ends. In addition, as the motor loss power amount, data of the upstream-side total power amount and the downstream-side total power amount calculated in the process for calculating the motor average efficiency described below are used.

With respect to the motor average efficiency, the input power and the output power are detected, and by the powering and regeneration signal, the input power Pin during the powering and the output power Pout during the regeneration are classified as the upstream-side powers, and the output power Pout during the powering and the input power Pin during the regeneration are classified as downstream-side powers. After classification as the upstream-side powers and the downstream-side powers, negative polarity is subjected to the absolute value processing. Thereafter, integration is respectively performed to obtain the upstream-side total power amount and the downstream-side total power amount, and the motor average efficiency ηav within this operation period is calculated by one division of the downstream-side total power amount by the upstream-side power amount.

In addition, since the upstream-side total power amount and the downstream-side total power amount have already been obtained, the motor lower power amount is calculated by subtracting the downstream-side total power amount from the upstream-side total power amount.

If the above content is expressed as a formula, the motor average efficiency ηav becomes Formula (10), and the motor loss power amount PTloss becomes Formula (13).

$$\eta av = (A/B) \times 100 \ (\%) \ \dots \ (10)$$

Herein, A: downstream-side power amount (Wh)
B: upstream-side power amount (Wh)

Herein, the downstream-side power amount A and the upstream-side power amount B are expressed by Formula (11) and Formula (12).

$$A = \int (\text{output power during the powering}) dt + \int (|\text{input power}$$

$$\text{during the regeneration}|) dt \ (\text{Wh}) \ \dots \ (11)$$

$$B = \int (\text{input power during the powering}) dt + \int (|\text{output power}$$

$$\text{during the regeneration}|) dt \ (\text{Wh}) \ \dots \ (12)$$

$$PTloss = B - A \ (Wh) \ ... \ (13)$$

Hereinafter, the operation will be described with reference to Fig. 1.

In Fig. 1, the input power Pin, the output power Pout, the powering signal MS, and the regeneration signal GS of the motor are input to the synchronized switching circuit 2. During the powering, the powering signal MS becomes "H", and the 2a switch 9 of the Pin and the PXin becomes conductive so that the input and the output become parallel, and the Pout and the PXout become conductive. At this time, due the powering state, the upstream side is the power supply side, and thus, the PXin side becomes the upstream side signal. In addition, the downstream side is the load side, and thus, the PXout becomes the downstream side signal. When the powering signal MS is "L", the 2a switch 9 is open, and the input power Pin and the output power Pout are treated as zero data.

On the other hand, during the regeneration, the regeneration signal GS becomes "H", and the 2a switch 9 of the Pout and the PXin becomes conductive so that the input and the output cross, and the Pin and the PXout become conductive. At this time, due to the regeneration state, the upstream side is the load side, and thus, the PXin side becomes the upstream side signal. In addition, the downstream side is the power supply side, and thus, the PXout becomes the downstream side signal. When the regeneration signal GS is "L", the 2a switch 9 is open, and the input power Pin and the output power Pout are treated as zero data.

In the boundary region between the powering and the regeneration, both the powering signal MS and the regeneration signal GS become "L", and the two sets of 2a switches 9 become open, so that the input power Pin and the output power Pout are treated as zero data.

In this manner, by the powering signal MS and the regeneration signal GS, the input power Pin during the powering is classified as the upstream-side power, the output power Pout during the regeneration is classified as the upstream-side power, the output power Pout during the powering is classified as the downstream-side power, and the input power Pin during the regeneration is separated into the downstream-side power. In addition, the signal PXin on the output side of the synchronized switching circuit 2 is classified so as to always be the upstream-side signal, and the signal PXout is classified so as to always be the downstream-side signal.

The outputs PXin and PXout of the synchronized switching circuit 2 are respectively input to the absolute value circuit 4. The negative value is subjected to the absolute value processing to become a positive value, and the positive value is output as a positive value. The upstream-side signal PWin and the downstream-side signal PWout are output.

Next, the upstream-side signal PWin and the downstream-side signal PWout are input to the integration circuit 5. In the integration circuit 5, when the measurement start/stop signal S/H becomes "H", the PWin and the PWout are respectively input in a certain cycle, and the integration operation is started. With respect to the integration operation, the integration operation is continued until the S/H becomes "L". When the S/H becomes "L", the integration operation is stopped, and the integrated data are retained to obtain the total integrated power amount.

In addition, when the measurement start/stop signal S/H becomes "L", the data is transmitted to the resistor 8 of the output of each integration circuit 5 at the rising edge of the inverter gate circuit 3. As the output of the resistor 8, the upstream-side signal is Pdin, and the downstream-side signal is Pdout. These signals are input to the division circuit 6, and the downstream-side signal Pdout is divided by the upstream-side signal Pdin according to Formula (10), so that the motor average efficiency ηav is output.

On the other hand, as the output of the resistor 8, Pdin is the upstream-side signal (B in Formula (13)), and Pdout is the downstream-side signal (A in Formula (13)). Formula (13) is calculated by the subtraction circuit 7, so that the motor loss power amount PTloss is output.

In addition, the input power Pin input to the average efficiency/loss calculation circuit 1 is input to the positive output circuit 47 and the negative output circuit 48, and the outputs thereof are integrated by the integration circuit 5. Then, the powering side input power amount PTmin which is the output on the +side of the input power Pin and the regeneration side input power amount PTgin which is the output on the -side of the input power pin are output. Similarly, the output power Pout is input to the positive output circuit 47 and the negative output circuit 48, and the outputs thereof are integrated by the integration circuit 5. Then, the powering side output power amount PTmout, which is the output on the +side of the output power Pout and the regeneration side output power amount PTgout which is the output of the - side of the output power Pout are output. In addition, the average efficiency/loss calculation circuit 1 is configured to record the operating time measured during the period when the measurement start/stop signal S/H is at H level by the measurement timer 45, and thus, the operating time data is also output together with various output data ηav, PTloss, PTmin, PTgin, PTmout, and PTgout.

The above-described PTmin, PTgin, PTmout, and PTgout are separated into two types of the powering and the regeneration and further separated into two types of the input power amount and the output power amount, so that these are separated into four types of signals. The reason for this is that the load conditions of the motor, for example, the tendency of load such as a frictional load, a gravitational load, an inertial load, or a wind hydraulic load are not known by the motor average efficiency ηav or the motor loss power amount PTloss alone within the operation period of one process. In addition, it is not known whether the load is a heavy load or a light load and whether the frequency of the powering driving and the regeneration driving is low or high. This is because these four types of signals are used to know which signal is larger and which signal is smaller, the tendency of the load is known from the numerical values, and it is estimated whether the driving is energy saving driving or wasteful driving.

In addition, the signals corresponding to the upstream-side signal Pdin of the output of the resistor 8 and the downstream-side signal Pdout of the output of the resistor 8 illustrated in the upper portion of Fig. 1 can be obtained from the four types of signals by calculation of Formulas 14 and 15. Herein, PTgout and PTgin are negative values.

$$\text{Pdin = PTmin + (absolute value of PTgout) = PTmin}-\text{PTgout}$$

$$\text{(Wh) ... (14)}$$

Herein, PTmin: Input power amount (Wh) during the powering
PTgout: Output power amount (Wh) during the regeneration

$$\text{Pdout = PTmout + (absolute value of PTgin) = PTmout}-\text{PTgin}$$

$$\text{(Wh) ... (15)}$$

Herein, PTmout: output power amount (Wh) during the powering
PTgin: Input power amount (Wh) during the regeneration

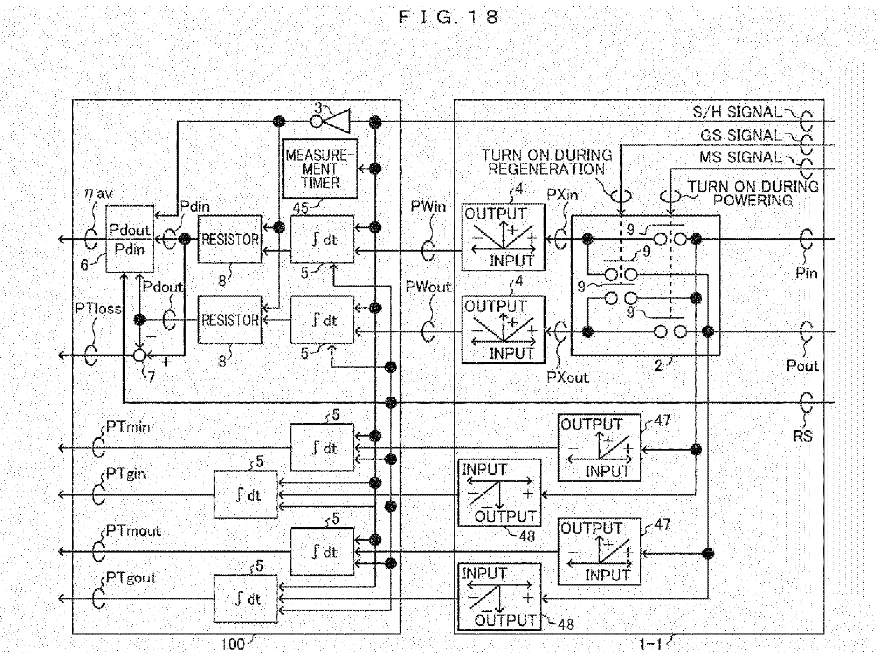

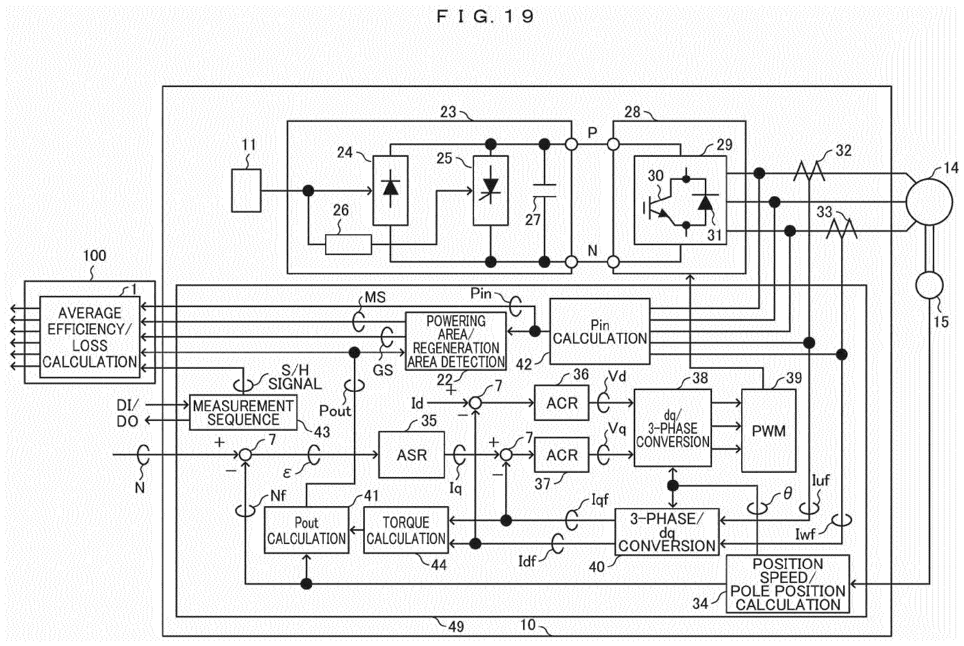

In addition, since the Pdin calculated by the above Formula corresponds to B in Formula (10) and the Pduot corresponds to A in Formula (10), with respect to the motor average efficiency $\eta$av and the motor loss power amount PTloss, by inserting the four types of signals PTmin, PTgin, PTmout, and PTgout into the external calculation device, obtaining Formulas (14) and (15), and calculating Formulas (10) and (13), and thus, the contents in the upper diagram of Fig. 1 may be realized. In addition, an example of causing an external calculation device (higher-level device) to perform calculation illustrated in Figs. 18 and 19.

Fig. 18 is a diagram illustrating another configuration of the average efficiency/loss calculation circuit in the present embodiment. In Fig. 18, in the configuration of average efficiency/loss calculation circuit 1 of Fig. 1, the processing after the integration circuit 5 is configured to be calculated by external calculation device (higher-level device) 100, and the remaining processing is configured to be performed by the average efficiency/loss calculation circuit 1-1 in the motor power conversion device. In addition, Fig. 19 is a diagram illustrating the other whole configuration in which the motor power conversion device according to the present embodiment is applied to a permanent magnet type motor. In Fig. 19, the average efficiency/loss calculation circuit 1 of Fig. 6 is configured so as to be entirely operated by the external calculation device (higher-level device) 100. Accordingly, it is possible to reduce the processing in the motor power conversion device.

The synchronized switching circuit 2, the absolute value circuit 4, the integration circuit 5, the division circuit 6 or the subtraction circuit 7, the positive and negative output circuits 47 and 48, and the switch 9 in the average efficiency/loss calculation circuit 1 described above are realized by a cooperation of a calculation device such as a CPU and a DSP and software.

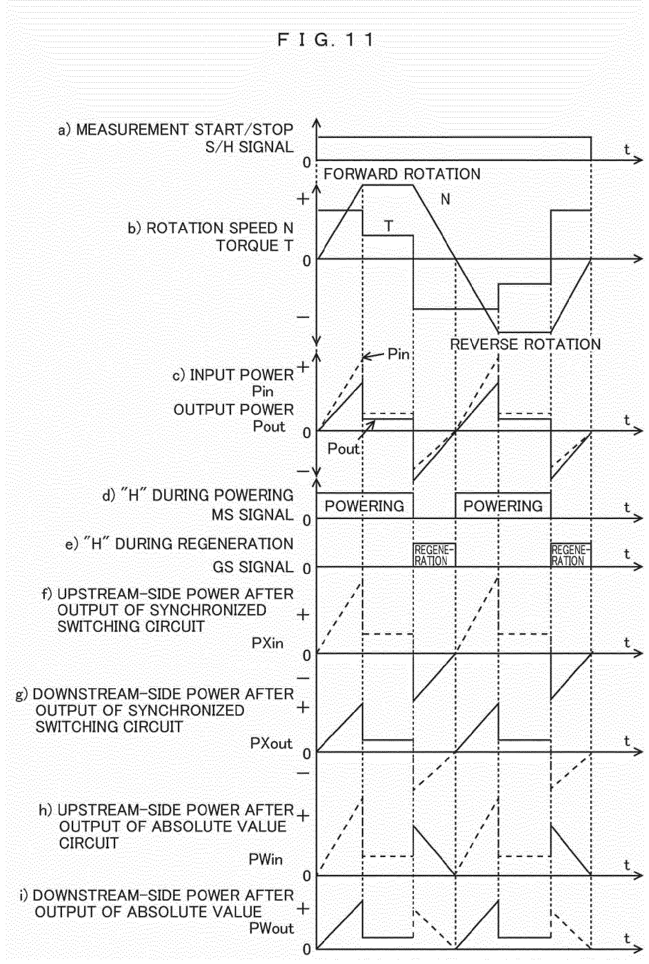

Fig. 11 is a timing chart illustrating the operations of Fig. 1. In Fig. 11, (a) illustrates the level of measurement start/stop signal S/H in the motor average efficiency/loss calculation. In addition, (a) illustrates that the average efficiency/loss amount of the motor driving operation is measured during the period when the measurement start/stop signal S/H is "H". (b) illustrates the motor rotation speed N that is operated in a trapezoidal operation pattern of one cycle of positive and negative and the operation of the motor torque T at that time.

In Fig. 11, (c) illustrates the value obtained by calculating the output power Pout from the motor rotation speed N and torque T of (b) from Formula (4), and the input power Pin illustrates the value detected by the input power calculation circuit 42 illustrated in Fig. 7. The solid line is the output power Pout of the motor, and the broken line is the input power Pin.

In Fig. 11, (d) and (e) illustrate the powering signal MS and the regeneration signal GS, which are output signals of the powering area/regeneration area detection circuit 22. In Fig. 11, (f) illustrates a waveform of the upstream-side power PXin of the output of the synchronized switching circuit 2. By the operation of the synchronized switching circuit 2, since the upstream side is the input power of the motor during the powering, the switch 9 of PXin and Pin (indicated by the broken line) is turned on, and since the upstream side is the output power during the regeneration, the switch 9 of the PXin and the Pout (indicated by the solid line) is turned on.

In Fig. 11, (g) illustrates a waveform of the downstream-side power PXout of the output of the synchronized switching circuit 2. By the operation of the synchronized switching circuit 2, since the downstream side is the output power of the motor during the powering, the switch 9 of the PXin and the Pout (indicated by the solid line) is turned on, and since the downstream side is the input power during the regeneration, the switch 9 of the PXin and the Pin (indicated by the broken line) is turned on.

In Fig. 11, (h) illustrates a result of the absolute value processing of a waveform of (f) with the upstream-side power PWin after the output of the absolute value circuit. In addition, in Fig. 11, (i) illustrates a result of the absolute value processing of a waveform of (g) with the downstream-side power PWout after the output of the absolute value circuit.

The signals of (h) and (i) of Fig. 11 are integrated by the integration circuit 5, so that the upstream-side power amount and the downstream-side power amount are obtained.

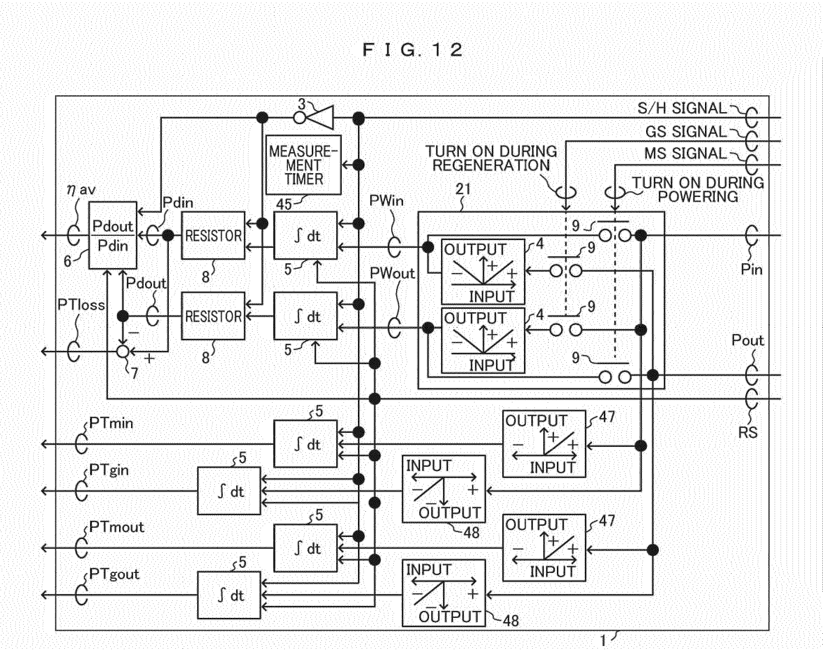

Fig. 12 is a diagram illustrating an example in which the average efficiency/loss calculation circuit 1 of the present embodiment is implemented with another configuration. The difference from Fig. 1 is that the synchronized switching circuit 2 and the absolute value circuit 4 in Fig. 1 are replaced with a synchronized switching rectification circuit 21 in Fig. 12, and the absolute value circuit 4 in Fig. 1 is configured to be inserted in series with switches 9 crossing each other in Fig. 12. This is because the absolute value circuit 4 is inserted in series with the 2a switches 9 which turn on and cross each other during the regeneration since both the input power Pin and the output power Pout have negative polarity during the regeneration. Accordingly, the absolute value processing is performed only during the regeneration. Since Fig. 11 which is the timing chart illustrating the operations of Fig. 1 is not changed in Fig. 12, the timing chart of Fig. 11 is commonly used.

In addition, the synchronized switching rectification circuit 21, the absolute value circuit 4, the integration circuit 5, the division circuit 6 or the subtraction circuit 7, the positive and negative output circuits 47 and 48, and the switch 9 in the average efficiency/loss calculation circuit 1 described in Fig. 12 are realized by a cooperation of a calculation device such as a CPU or a DSP and software.

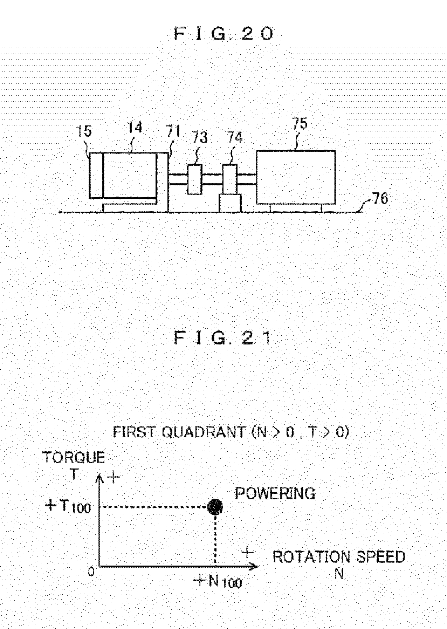

Fig. 20 is a diagram illustrating a motor efficiency measurement method in the related art. In an efficiency evaluation method in a motor manufacturing factory, a test motor 14 is attached to an L-shaped motor mount 71 and is connected to a simulated load device 75 through a torque pickup 74 by the connector 73 on a motor output shaft. The test motor 14 to be evaluated is operated at the rated rotation speed, and the simulated load device 75 is adjusted so that the test motor has the rated torque. After that, the temperature rising test is performed, and after the temperature rising value of the test motor coil is saturated, the input power of the test motor 14 is read from a power meter. The output power is obtained by multiplying (rated torque $\times$ rotation speed of the output shaft) by a proportional coefficient according to Formula (4). Therefore, the efficiency during the powering at the time of the rated motor = (output power/input power) $\times$ 100 (%) is calculated. In addition, it is not possible for the final user to perform this motor efficiency measurement because there is no simulated load device to apply the load.

Fig. 21 is a diagram illustrating a motor efficiency measurement point on rotation speed-torque coordinates in the related art. The operating condition of the motor efficiency measurement performed by using the test motor 14 to be evaluated is that the measurement is performed only in the powering state with the torque fixed at a rated torque ($+T_{100}$) and the rotation speed fixed at the rated rotation speed ($+N_{100}$). Fig. 21 illustrates this condition on the rotation speed-torque coordinates, where the operating point is one point in the figure, and there is no change in speed.

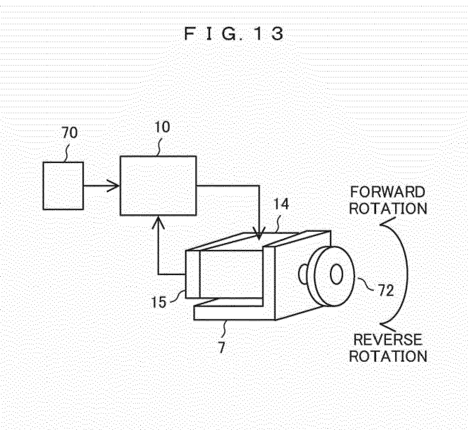

Fig. 13 is a configuration diagram illustrating a motor efficiency measurement method according to the present embodiment. User's demand is that, as the load machine to be used at the end user's site, by the servo amplifier, the DCBL controller, the inverter, or the vector control inverter with the repetitive load pattern that is actually operated, the motor itself is driven, and thus, the efficiency of its own motor is measured while being moving on the production line. For this reason, in the present embodiment, the magnitude of the motor torque is varied by changing the acceleration during the forward rotation operation and the reverse rotation operation by using the rotor inertia momentum of the motor without using a simulated load, and the efficiency of the motor is measured while generating, for example, 0 through 100% to 300%, in a range of from 0 through the rated torque to the maximum torque.

In other words, the output power of the motor is calculated by giving acceleration or rotational acceleration as the speed command given to the motor and using the accelerated/decelerated torque generated by the inertia momentum of the rotor of the motor and the motor rotation speed repeating acceleration/deceleration, and the efficiency of the motor is measured. In addition, in a case where the load has a frictional load, the acceleration torque can be increased by changing the acceleration except for the torque corresponding to the frictional load. In punching machines and surface mounters, an operation at a hit rate of approximately 500 times/min or high-speed mounting with a tact time of 0.18 seconds/chip is performed, and this is the operation at the highest speed level in the industries and is sufficient to allow the torque to occur. Fig. 13 illustrates a configuration in which the acceleration during the forward rotation operation and the reverse rotation operation can be changed by removing the motor from the machine and attaching a load disc to the motor alone or the motor output shaft so that the motor efficiency measurement condition is not limited to the user's machine.

First, an L-shaped motor mount 71 is attached to the AC motor 14, and the motor output shaft is opened and maintained in a free state. However, in a case where an additional inertia momentum is required for the rotating portion, the load disc 72 is attached to the motor output shaft. Herein, the reason for attaching the load disc 72 is that, in a case where the rotor inertia momentum of the motor is small, the acceleration time and the deceleration time of the motor become short. In the present embodiment, the input power Pin and output power Pout of the motor are detected during acceleration and deceleration, but the detection cycle is a certain sampling cycle determined by the load factor of the software of the microcomputer or the DSP. Since the sampling cycle is a certain time interval, if the acceleration or deceleration time is short, the number of times of sampling becomes insufficient, and thus, continuous data cannot be obtained, so that the resolution is deteriorated. In such a case, the load disc 72 is attached to the motor output shaft, and the acceleration and deceleration time are increased by the combined rotor inertia momentum, so that the resolution is improved by increasing the number of times of sampling. In addition, in the future, if the processing capacity of the microcomputer or the DSP is improved, the sampling time is shortened, and thus, the number of times of sampling can be increased, so that the resolution can be improved without the load disc 72.

Next, the motor power conversion device 10 for driving the motor may use the motor power conversion device 10 delivered to the user, and as a command device, an external setting device 70 may be prepared. In addition, the external setting device 70 is not necessarily required. A command can be given from the efficiency/loss measurement command circuit 69 incorporated in the motor power conversion device 10.

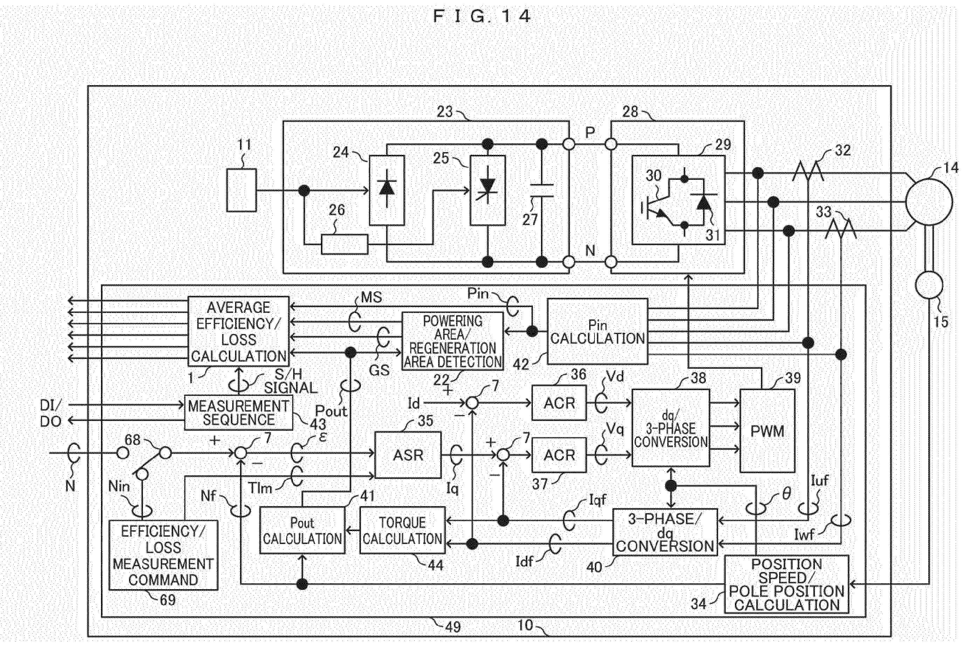

Fig. 14 is a block diagram in which the efficiency/loss measurement command circuit is added to the overall configuration diagram of the motor power conversion device of Fig. 6. As the portions added in Fig. 14 with respect to Fig. 6, the efficiency/loss measurement command circuit 69 that can be internally set to the speed command N of the motor power conversion device 10 is provided, and the switch SW 68 that switches an external speed command output and an internal setting output is added. Accordingly, the motor average efficiency/loss power amount can be measured from the efficiency/loss measurement command circuit 69 in the motor power conversion device 10 through the switch SW 68. In addition, if the switch SW 68 is switched to the external speed command side, it is possible to measure the efficiency of the motor while moving the production line with the repetitive load pattern itself that is actually operated by the load machine that is actually used.

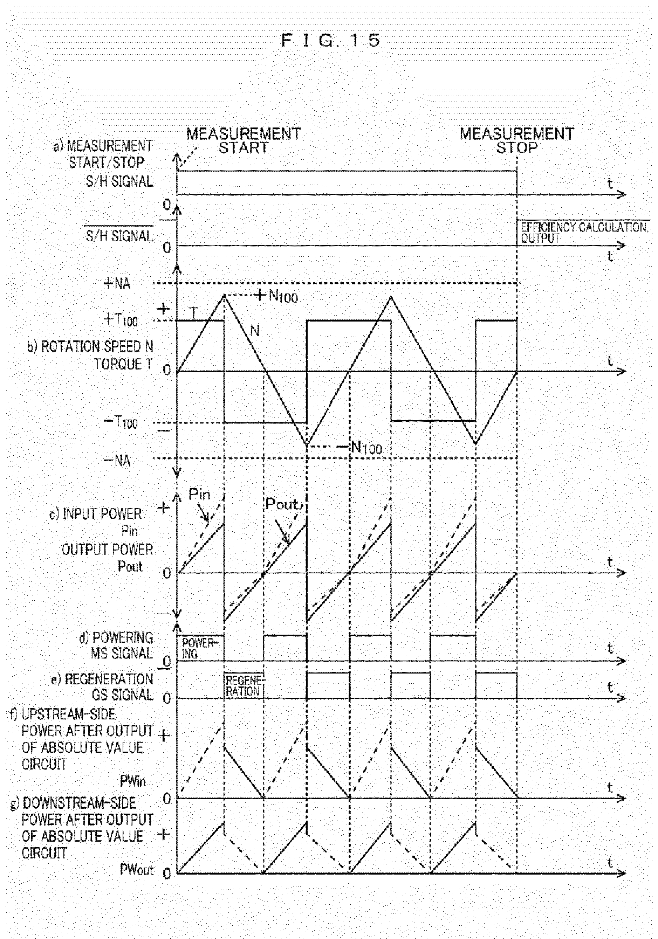

Fig. 15 is a diagram illustrating a timing chart of the motor average efficiency measurement in forward and reverse powering and regeneration driving. Fig. 15 illustrates the case where the switch SW 68 that is switched between the external speed command and the internal speed command in Fig. 14 is set to the internal speed command side. In the case of the internal speed command, without limiting the motor efficiency measurement conditions to the user's machine, by detaching the motor from the machine and by using the motor alone or the motor attached with a load disc, it is possible to measure the motor average efficiency.

Fig. 15 (a) illustrates the level of measurement start/stop signal S/H of the motor average efficiency/loss calculation. It is illustrated that the average efficiency/loss amount of the motor driving operation is measured during the period when the measurement start/stop signal S/H is "H". In addition, the inverted signal of the measurement start/stop signal S/H is illustrated below, and the output of the inverter gate circuit 3 in Figs. 1 and 12 and the input signals to the resistor 8 and the division circuit 6 are illustrated.

Fig. 15 (b) illustrates the operation of driving in a triangular waveform pattern where positive and negative motor rotation speeds N alternately repeat. The motor torque is alternately set to a positive rated torque $+T_{100}$ and a negative rated torque $-T_{100}$. The speed command is set to $+NA$ exceeding the positive rated rotation speed $+N_{100}$ or $-NA$ exceeding the negative rated rotation speed $-N_{100}$.

First, when the speed command is set to $+NA$, and the actual speed N is increased from zero to a positive rated rotation speed $+N_{100}$, the speed command is switched from the forward-rotation $+NA$ to the reverse-rotation $-NA$, and the motor torque is switched to a negative rated torque $-T_{100}$. By this switching operation, the actual speed is decreased from $+N_{100}$ to zero speed, and after passing zero speed, the actual speed is increased to the reverse rotation side. Then, when the actual speed reaches $-N_{100}$, the speed command is switched from the reverse-rotation $-NA$ to the forward-rotation $+NA$. When the motor torque is switched to the positive rated torque $+T_{100}$ by this switching operation, the actual speed is changed from $-N_{100}$ as the reverse-rotation speed is decreased and the actual speed becomes zero. When the actual speed passes the zero speed, the speed is accelerated toward the initial positive rated rotation speed $+N_{100}$, and this cycle is repeated (refer to the torque T and the rotation speed N in Fig. 15(b)). In Fig. 15, since the S/H signal of the measurement start/stop is given in two cycles (refer to (a) of Fig. 15), the motor average efficiency/loss power amount in this period is measured.

Herein, since the motor torque illustrated in Fig. 15 is alternately repeated as the positive rated torque $+T_{100}$ and the negative rated torque $-T_{100}$, the effective torque to be applied to the motor is calculated as $+T_{100}$. If attention is paid on only the torque, the torque becomes the rated torque $+T_{100}$ which is the same as that of the motor efficiency measurement method in the related art of Fig 21. In the motor efficiency measurement method in the related art, the motor is connected on the motor output shaft through the connector 73 to the torque pickup 74 and the simulated load device 75, and the simulated load device 75 is adjusted so that the torque of the test motor becomes the rated torque $+T_{100}$.

However, in the method in the related art, the rotation speed is a constant rated rotation speed $+N_{100}$. On the contrary, in the present embodiment, linear acceleration is performed from the zero speed to the positive rated rotation

speed $+N_{100}$, then linear deceleration is performed toward the negative rotation speed $-N_{10C}$, and after passing the zero speed linear acceleration is performed reversely to reach $-N_{100}$. After that, deceleration is performed reversely to pass the zero speed. The different point after that is that this repeats. The measurement of the rotation speed in the present embodiment can be said to be efficiency measurement in a harsher condition than the method in the related art. However, the operating condition of the punching machine, the surface mounting machine, or the like can be said to be an actual operating condition and is close to the original operating condition of a servo motor. The input power Pin and the output power Pout in Fig. 15 (c) are obtained by multiplying the product of the rotation speed N and the torque T in Fig. 15 (b) by the proportionality constant of Formula (4). The powering signal MS in Fig. 15 (d), the regeneration signal GS in Fig. 15 (e), the upstream-side power PWin in Fig. 15 (f), and the downstream-side power PWout in Fig. 15 (g) are processed in the same manner as in Fig. 11 and become as illustrated in Fig. 15. In addition, although the above description has been made on the operation in a triangular waveform pattern where the motor rotation speed N is alternately repeated as positive and negative values, the operation may have a non-negative triangular waveform pattern.

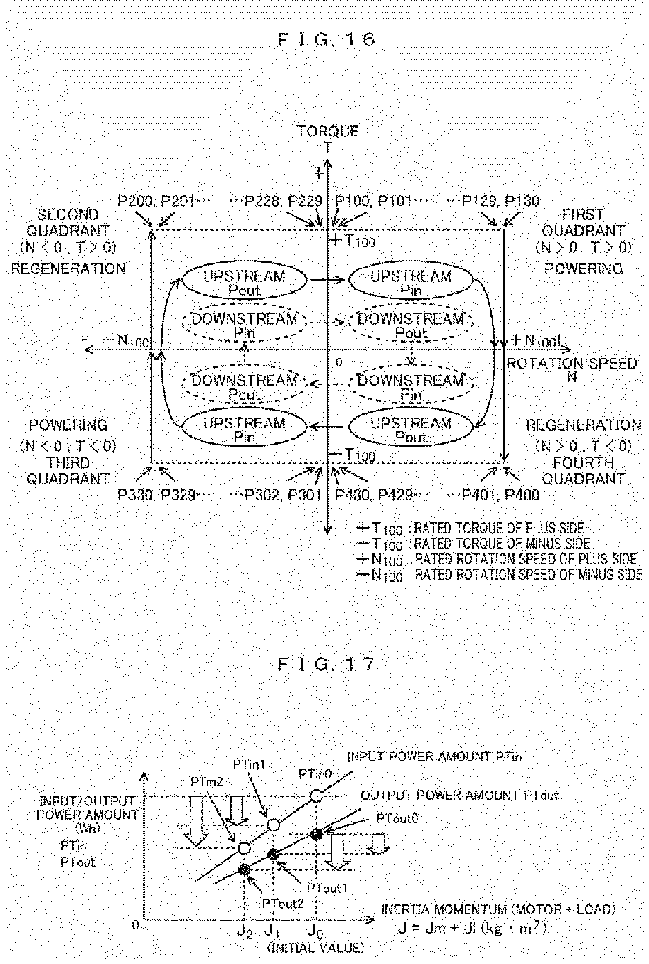

Fig. 16 is a diagram illustrating the integration of the upstream power and the downstream power on the rotation speed-torque coordinates in the timing chart of Fig. 15. The x-axis is the rotation speed N, and the y-axis is the torque T in the rectangular coordinates. The first quadrant and the third quadrant are powering areas, and the second quadrant and the fourth quadrant are regeneration areas. Fig. 16 illustrates the operations of the timing chart of Fig. 15 as a locus of driving on the N-T coordinates. First, the locus starts from the origin, turns twice clockwise as the first quadrant --> the fourth quadrant --> the third quadrant -> the second quadrant, and then, stops. The measurement start/stop S/H signal is "H" in the period of two cycles, and the motor efficiency/loss is measured. By dividing the rotation speed N between zero and the rated rotation speed, herein, as an example, into 30 sections, in the first quadrant, the input power Pin and the output power Pout of the motor are measured at points of from P100 to P130. In addition, in P1, P denotes a point, and 1 denotes a first quadrant.

With respect to the driving locus on the rotation speed-torque coordinates, since the torque is accelerated at a certain rate of positive rated torque $+T_{100}$, the rotation speed N is instantaneously increased vertically from zero and increased up to $+N_{100}$, and after that, the locus moves horizontally to the right along the point numbers P100, P101, ..., P129, and P130. If the locus exceeds P130, the operation shifts to the deceleration operation, the locus instantaneously moves vertically downward to P400 in the fourth quadrant. After that, at P401, ..., P429, and P430, the torque is constant at the negative rated torque $-T_{100}$, and the rotation speed is decreased from +N100, and the locus moves horizontally from the right to the left on the coordinates. The point P430 is the same as P300. The rotation speed becomes zero, and the rotational direction shifts from the forward rotation to the reverse rotation. The locus from this point enters the third quadrant and moves to the further left to P301, P302, ..., P329, and P330, and the rotation speed reaches the negative rated rotation speed. Herein, the torque changes to $+T_{100}$, the locus moves vertically upward and moves to $P_{200}$. After that, the locus moves horizontally from the left to the right along P201, ..., P228, P229, and P230 (the same point as P100), and the rotation speed returns to zero, and torque moves horizontally from the left to the right with a certain torque $+T_{100}$, and the locus circulates the remaining portions.

The details of the upstream-side signals and the downstream-side signals within the four quadrants are described. Since the first quadrant and the third quadrant are the same in the powering area, the upstream-side signal is Pin, and the downstream-side signal is Pout. In addition, since the second quadrant and the fourth quadrant are the same in the regeneration area, the upstream-side signal is Pout, and the downstream-side signal is Pin. The upstream-side signals are illustrated to be surrounded by ovals with solid lines in the figure and the upstream-side signals are integrated. In the first -> fourth -> third -> second quadrants, the upstream-side signals are integrated alternately with Pin -> Pout -> Pin -> Pout. On the other hand, the downstream-side signals are surrounded by ovals with broken lines in the figure, and the signals opposite to the upstream-side signals are alternately integrated.

Herein, for each point, in the powering area, the motor efficiency $\eta m$ is calculated by Formula (1), and the efficiency of 30 data is calculated from P130 to P130 in the first quadrant. In addition, in the regeneration area, in the fourth quadrant, the motor efficiency $\eta g$ is calculated by Formula (2), and the efficiency of 30 data is calculated from P400 to P429. Similarly, the efficiency of 30 data is calculated in the third quadrant, and the efficiency of 30 data is calculated in the second quadrant. By repeating the same operations for one cycle, the average values of the efficiency of a total of 240 data are calculated, and thus, the motor average efficiency within the measurement start/stop period can be obtained. However, this method involves division each time, which takes time for CPU and DSP calculation processing. For this reason, in the present embodiment, the input power and the output power of the motor are classified as the upstream-side power and the downstream-side power and then integrated (added in terms of processing) and subjected to absolute value processing. After that, the sum thereof is set to the total power amount. Finally, the motor average efficiency is obtained by calculating the division of the downstream-side power amount/the upstream-side power amount once.

Returning to Fig. 15, it is possible to accurately obtain the average efficiency corresponding to the motor efficiency data 240 equivalent to two cycles of the measurement period of the zero rotation speed to the positive and negative rotation speeds with rated torques of positive and negative powering and regeneration. In addition, with respect to one-cycle four sites (two-cycle eight sites) of a vertically downward movement from P100 (the same point as P230) and P430 (the same point as P300) with the zero rotation speed and P130 to P400 exceeding the zero torque and a vertically upward movement from P330 to P200, due to the boundary region between the powering and the regeneration described with reference to Figs. 9 and 10, the denominator and the numerator of the efficiency are treated as co-zero, and thus, no singular point does occur.

In the above description, in the coordinates where the x-axis represents the rotation speed and the y-axis represents the torque, with positive and negative rated torques for the powering and the regeneration, the areas of the zero rotation speed to the positive and negative rotation speeds are defined as four quadrants of from the first quadrant to the fourth quadrant, but the four quadrants are not necessarily required. The powering and regeneration states can occur in a combination of the two quadrants of the first quadrant and the fourth quadrant or in a combination of the two quadrants of the third quadrant and the second quadrant. Therefore, the motor average efficiency and the motor loss power amount can be measured in a range of from the zero rotation speed to the positive rated rotation speed with positive and negative rated torque for the powering and the regeneration or in a range of from the zero rotation speed to the negative rated rotation speed with positive and negative rated torque for the powering and the regeneration. Furthermore, the motor average efficiency and the motor loss power amount can be measured in a range between an arbitrary positive rotation speed and the positive rated rotation speed with positive and negative rated torque for the powering and the regeneration or in a range between an arbitrary negative rotation speed and the negative rated rotation speed with positive and negative rated torque for the powering and the regeneration.

Fig. 17 is a diagram illustrating the relationship between the reduction of the inertia momentum (motor + load) and the input and output power amounts. Fig. 17 illustrates how to measure the inertia momentum (of motor + load), as an example, in a high-speed reciprocating machine driving motor. In Fig. 17, the inertia momentum (of motor + load) is assigned to the x-axis, and the input power amount PTin and the output power amount PTout are assigned to the y-axis. The input power amount PTin and the output power amount PTout are calculated as PTin = PTmin + (absolute value of PTgin) and PTout = PTmout + (absolute value of PTgout) from the output signal of the average efficiency/loss calculation circuit 1 in Figs. 1 and 12. The inertia momentum (of motor + load) to be normally driven is denoted by $J_0$, and at this time, as a result of high-speed reciprocation, an output power amount PTout0 and an input power amount PTin0 are obtained.

Next, this is improved and the inertia momentum is reduced to $J_1$ and further to J2, and as a result of high-speed reciprocation, the output power amount PTout1 and the input power amount PTin1 are obtained for $J_1$, and the output power amount PTout2 and the input power amount PTin2 are obtained for $J_2$. Herein, with respect to the torque of the motor operating at a high speed, if the inertia momentum is decreased, the accelerated/decelerated torque of the motor is decreased in proportion to the decrease in the inertia momentum. It is known that the reduction in the torque also causes the motor output power (driving power) to be reduced. Similarly, the motor input power (power consumption) is also reduced. For this reason, as illustrated in the figure, it can be understood that, if the inertia momentum is reduced from the normal value (initial value) $J_0$ to $J_1$ and further to $J_2$, the output power is changed as illustrated by a black circle, and the input power is transitioned as illustrated by a white circle. As a result, the reduction amount of the power amount becomes a large value as indicated by the thick arrow, and the energy saving effect becomes large.

According to the above description, in the present embodiment, in the motor which is operated in repetitive load continuous use in which high-speed forward-rotation/reverse-rotation powering and regeneration states are repeated, with respect to whether the processing condition optimum for energy saving is satisfied or whether the motor efficiency is low, repetitive load patterns with which on-site machines actually used are actually operated, for example, a hit rate and a tact time are increased up or decreased down than usual, or a moving work is allowed to be lighter than usual, it is possible to accurately measure the efficiency and the loss power amount of the motor by the motor power conversion device while moving the production line.

In addition, in the method of measuring motor efficiency in the related art, even if the inertia momentum is reduced, the result illustrates no change in the data. However, in the present embodiment, since the positive and negative torques are alternately repeated to accelerate and decelerate the rotation speed to zero through the positive or negative rated rotation speed or to the maximum rotation speed, if the inertia momentum is reduced, the accelerated/decelerated torque of the motor is reduced in proportion to the reduction in the inertia momentum. The result is output as data in the present embodiment and can be displayed.

In the motor efficiency and input power and output power measurement methods in the related art, since the motor efficiency is measured at a certain rated torque and rated (maximum) rotation speed, this may be called an efficiency measurement method using static characteristics. Therefore, the method of measuring the efficiency by accelerating and decelerating the rotation speed from zero to the rated speed with the positive and negative rated torque may also be called an efficiency measurement method using dynamic characteristics.

In addition, the above can be measured by driving the load machine of an actual production line by the actual driving command. In addition, by detaching the motor from the machine and by using the motor alone or the motor attached with a load disc, without limiting the internal command of the motor power conversion device to the user's machine, the command dedicated to the measurement of the motor average efficiency/loss power amount for measuring the above can be selected.

As described above, a motor power conversion device according to the present embodiment includes: a synchronized switching circuit in which, when, in a flow of power flowing to a motor, powering is set to a direction from a power source to a load side and regeneration is set to a direction from the load to the power source side, as operations in one process of the motor, during the powering, an input power detection value of the motor is set to an upstream-side power, and an output power detection value of the motor is set to a downstream-side power, and during the regeneration, the output power detection value is set to the upstream-side power, and, the input power detection value is set to the downstream-side power; an absolute value circuit that performs absolute value processing on the upstream-side power and the downstream-side power; an integration circuit that integrates the upstream-side power and the downstream-side power subjected to the absolute value processing and outputs the integrated values as the upstream-side power amount and the downstream-side power amount; a division circuit that divides the downstream-side power amount by the upstream-side power amount to obtain a motor average efficiency; and a subtraction circuit that subtracts the downstream-side power amount from the upstream-side power amount to obtain a motor loss power amount.

Accordingly, the input power or the output power of the motor can be classified as the upstream-side power and the downstream-side power, and the average efficiency, the loss power amount, and the input and output power amounts of the motor can be calculated on the basis of the calculation formulas.

These are load machines on the actual production line and can be operated from the actual operation commands to calculate the average efficiency, the loss power amount, and the input power amount and the output power amount of the motor. In addition, by detaching the motor from the machine and by using the motor alone or the motor attached with a load disc, the average efficiency, the loss power amount, and the input power amount and the output power amount of the motor due to dynamic characteristics can be switched to the internal settings of the motor power conversion device for easy operation. Therefore, it is possible to clearly recognize whether the motor efficiency is poor or whether the motor loss power amount or the input and output power amounts is large. Accordingly, it is possible to obtain effects of improving the motor efficiency and easily improving the motor loss power amount and the input power and output power. In addition, it is possible to provide a motor power conversion device capable of accurately calculating the motor average efficiency and the motor loss power amount in the driving operation in which the motor frequently repeats the powering and regeneration states.

REFERENCE SIGNS LIST

| 1 | Average efficiency/loss calculation circuit |
| 2 | Synchronized switching circuit |
| 3 | Inverter gate circuit |
| 4 | Absolute value circuit |
| 5 | Integration circuit |
| 6 | Division circuit |
| 7 | Subtraction circuit |
| 8 | Resistor |
| 9 | Switch |
| 10 | Motor power conversion device |
| 11 | AC power supply |
| 12 | Leakage circuit breaker |
| 13 | Electromagnetic contactor |
| 14 | AC motor (permanent magnet motor, test motor) |
| 15 | Encoder |
| 16 | Motor output shaft |
| 17 | Various machines |
| 18 | Encoder cable |
| 19 | Motor power cable |
| 20 | Power supply power cable |
| 21 | Synchronized switching rectification circuit |
| 22 | Powering area/regeneration area detection circuit |
| 23 | Forward converter with power regeneration function |
| 24 | Converter for full wave rectification |
| 25 | Power regeneration converter |

| 26 | AC reactor for regeneration |
| 27 | Smoothing capacitor |
| 28 | Inverse converter |
| 29 | Multiphase inverter |
| 30 | Switching element |
| 31 | Flywheel diode |
| 32 | U-phase current detector CTu |
| 33 | W-phase current detector CTw |
| 34 | Position/speed/pole position calculator |
| 35 | Speed controller (ASR) |
| 36 | d-axis current controller (ACR) |
| 37 | q-axis current controller (ACR) |
| 38 | dq/3-phase conversion circuit |
| 39 | PWM circuit |
| 40 | 3-phase/dq conversion circuit |
| 41 | Output power calculation circuit |
| 42 | Input power calculation circuit |
| 43 | Measurement sequence circuit |
| 44 | Torque calculation circuit |
| 45 | Measurement timer |
| 47 | Positive output circuit |
| 48 | Negative output circuit |
| 49 | Control logic circuit |
| 50 | Filter circuit |
| 51 | Insulation amplifier |
| 52 | Multiplication operator |
| 53 | Inverting amplifier |
| 54 | Adder |
| 55 | 3-input addition operator |
| 68 | Switch SW |
| 69 | Efficiency/loss measurement command circuit |
| 70 | External setting device |
| 72 | Load disc |
| 100 | External calculation device (higher-level device) |

## Claims

1. A motor power conversion device configured to convert power to a motor (14), and further configured to obtain a motor average efficiency ($\eta$av) and a motor loss power amount (PTloss) of a motor (14), to obtain an electrical power detection value (Pin) of the motor by multiplying voltage and current values, and to obtain a mechanical power detection value (Pout) of the motor (14) by multiplying a rated torque and a rotation speed of the output shaft (16) of the motor (14); **characterized by** comprising:

   - a switching circuit (2) configured, in a powering mode in which a direction of power flow is from a power source to a load, to set the electrical power detection value (Pin) of the motor (14) as an upstream-side power (PXin), and to set the mechanical power detection value (Pout) of the motor (14) as a downstream-side power (PXout), and in a regeneration mode in which a direction of power flow is from the load to the power source, to set the mechanical power detection value (Pout) as the upstream-side power (PXin), and to set the electrical power detection value (Pin) as the downstream-side power (PXout);
   - an absolute value circuit (4) that performs absolute value processing on the upstream-side power (PXin) and the downstream-side power (PXout);
   - an integration circuit (5) that integrates the upstream-side power and the downstream-side power subjected to the absolute value processing (PWin, PWout) and outputs the integrated values as the upstream-side power amount (Pdin) and the downstream-side power amount (Pdout);
   - a division circuit (6) that divides the downstream-side power amount (Pdout) by the upstream-side power amount (Pdin) to obtain the motor average efficiency ($\eta$av); and
   - a subtraction circuit (7) that subtracts the downstream-side power amount (Pdout) from the upstream-side power amount (Pdin) to obtain the motor loss power amount (PTloss).

2. The motor power conversion device (10) according to claim 1, wherein the absolute value circuit (4) performs the absolute value processing only during the regeneration.

3. The motor power conversion device (10) according to claim 1 or 2, further comprising a powering area/regeneration area detection circuit (22) that outputs a powering signal (MS) indicating the powering and a regeneration signal (GS) indicating the regeneration, which are inputs to the switching circuit (2), wherein, in the powering area/regeneration area detection circuit (22), a boundary region at the time of switching between the powering signal and the regeneration signal is provided, at the time of switching from the powering to the regeneration of the motor (14), a time when the output power of the motor (14) becomes zero is set to an entrance of the boundary region, and a time when the input power of the motor (14) becomes zero is set to an exit of the boundary region, at the time of switching from the regeneration to the powering of the motor (14), a time when the input power of the motor (14) becomes zero is set to an entrance of the boundary region, and a time when the output power of the motor (14) becomes zero is set to an exit of the boundary region, and within the boundary region, the input power and output power of the motor are allowed to be zero in the switching circuit (2) .

4. The motor power conversion device (10) according to claim 1 or 2, further comprising an output power calculation circuit (41) that calculates the output power (Pout) of the motor,
   wherein the output power calculation circuit (41):

   applies acceleration or rotational acceleration to a speed command given to the motor in a state where the output shaft (16) of the motor is opened or a load disc (72) is attached to the output shaft (16) of the motor, and the rotor of the motor or the motor (14) and calculates the output power of the motor (14) according to an accelerated/decelerated torque generated due to inertia of a rotor of the motor or inertia of the rotor of the motor and the load disc (72) and a motor rotation speed repeating acceleration/deceleration;
   measuring the motor average efficiency ($\eta$av) by the division circuit (6) using the output power of the motor (14); and
   measuring the motor loss power amount by the subtraction circuit (7) using the output power of the motor (14).

5. The motor power conversion device (10) according to claim 1 or 2, further comprising:

   a measurement command circuit (69) that limits a motor torque to positive and negative rated torque by the motor (14) alone or a load disc (72) attached to a motor output shaft (16) is used, is provided with two speed commands of positive and negative speed commands, is switched to any one of the speed commands of positive and negative when a speed on the way being directed to any one of the two speed commands of the positive and negative speed commands on the reverse rotation side is detected, and is alternately switched to any one of the positive and negative speed commands on the forward rotation side when a speed on the way of the reverse rotation side is detected; and
   a switching circuit (2) that inputs an operation command of a repetitive load pattern operated by a load machine to be actually used and switches the speed command from the measurement command circuit (69).

6. The motor power conversion device (10) according to claim 5,

   wherein the detected speed on the way being directed to the two speed commands of the positive and negative speed commands is set to an arbitrary rotation speed and positive and negative rated rotation speeds, and
   wherein the motor average efficiency ($\eta$av) and the motor loss power amount are values in which the motor (14) has a rated torque, and the rotation speed includes a range of from the arbitrary rotation speed including zero to the positive and negative rated rotation speeds.

7. A motor power conversion system comprising:

   a motor power conversion device (10) that converts power to a motor (14) according to claim 1; and
   a higher-level device (100) that outputs a command to the motor power conversion device (10),
   wherein the motor power conversion device (10) further includes:

   an output power calculation processing unit (41) that calculates output power of the motor (14);
   an input power calculation processing unit (42) that calculates input power of the motor; and

an average efficiency/loss calculation processing unit (1),
wherein the average efficiency/loss calculation processing unit includes:

the switching circuit (2);
the absolute value circuit (4), and
wherein the higher-level device (100) includes:

the integration processing unit (5);
the division processing unit (6);
the subtraction circuit (7).

8. A motor power conversion system comprising:

a motor power conversion device (10) that converts power to a motor (14) according to claim 1; and
a higher-level device (100) that outputs a command to the motor power conversion device (10),
wherein the motor power conversion device (10) further includes:

an output power calculation processing unit (41) that calculates output power of the motor; and
an input power calculation processing unit (42) that calculates input power of the motor,
wherein the higher-level device (100) includes an average efficiency/loss calculation processing unit (1), and
wherein the average efficiency/loss calculation processing unit (1) includes:

the switching circuit (2);
the absolute value circuit (4);
the integration circuit (5);
the division circuit (6); and
the subtraction circuit (7).

**Patentansprüche**

1. Motorleistungsumsetzungsvorrichtung, die konfiguriert ist, die Leistung für einen Motor (14) umzusetzen, und ferner konfiguriert ist, einen mittleren Motorwirkungsgrad ($\eta$av) und einen Motorverlustleistungsbetrag (PTloss) eines Motors (14) zu erhalten, einen Detektionswert einer elektrischen Leistung (Pin) des Motors durch Multiplizieren eines Spannungs- und eines Stromwerts zu erhalten und einen Detektionswert einer mechanischen Leistung (Pout) des Motors (14) durch Multiplizieren eines Nenndrehmoments und einer Drehzahl der Ausgangswelle (16) des Motors (14) zu erhalten;
**dadurch gekennzeichnet, dass** sie umfasst:

- eine Schalt-Schaltung (2), die konfiguriert ist, in einer Stromversorgungsbetriebsart, in der die Richtung eines Leistungsflusses von einer Stromquelle zu einer Last ist, den Detektionswert einer elektrischen Leistung (Pin) des Motors (14) als eine aufwärtsseitige Leistung (PXin) einzustellen und den Detektionswert einer mechanischen Leistung (Pout) des Motors (14) als eine abwärtsseitige Leistung (PXout) einzustellen und in einer Regenerationsbetriebsart, in der die Richtung des Leistungsflusses von der Last zu der Stromquelle ist, den Detektionswert einer mechanischen Leistung (Pout) als die aufwärtsseitige Leistung (PXin) einzustellen und den Detektionswert einer elektrischen Leistung (Pin) als die abwärtsseitige Leistung (PXout) einzustellen;
- eine Absolutwertschaltung (4), die eine Absolutwertverarbeitung an der aufwärtsseitigen Leistung (PXin) und der abwärtsseitigen Leistung (PXout) ausführt;
- eine Integrationsschaltung (5), die die aufwärtsseitige Leistung und die abwärtsseitige Leistung, die der Absolutwertverarbeitung (PWin, PWout) unterzogen wurden, integriert und die integrierten Werte als den Betrag der aufwärtsseitigen Leistung (Pdin) und den Betrag der abwärtsseitigen Leistung (Pdout) ausgibt;
- eine Divisionsschaltung (6), die den Betrag der abwärtsseitigen Leistung (Pdout) durch den Betrag der aufwärtsseitigen Leistung (Pdin) teilt, um den mittleren Wirkungsgrad des Motors ($\eta$av) zu erhalten; und
- eine Subtraktionsschaltung (7), die den Betrag der abwärtsseitigen Leistung (Pdout) von dem Betrag der aufwärtsseitigen Leistung (Pdin) subtrahiert, um den Motorverlustleistungsbetrag (PTloss) zu erhalten.

2. Motorleistungsumsetzungsvorrichtung (10) nach Anspruch 1, wobei die Absolutwertschaltung (4) die Absolutwertverarbeitung nur während der Regeneration ausführt.

**3.** Motorleistungsumsetzungsvorrichtung (10) nach Anspruch 1 oder 2, die ferner eine Schaltung zur Detektion eines Stromversorgungsbereichs/Regenerationsbereichs (22) umfasst, die ein Stromversorgungssignal (MS), das die Stromversorgung angibt, und ein Regenerationssignal (GS), das die Regeneration angibt, die Eingaben in die Schalt-Schaltung (2) sind, ausgibt,

wobei in der Schaltung zur Detektion eines Stromversorgungsbereichs/Regenerationsbereichs (22) ein Grenzbereich zu dem Zeitpunkt des Schaltens zwischen dem Stromversorgungssignal und dem Regenerationssignal bereitgestellt wird, wobei zu dem Zeitpunkt des Schaltens von der Stromversorgung zu der Regeneration des Motors (14), ein Zeitpunkt, zu dem die Ausgangsleistung des Motors (14) null wird, auf einen Eingang des Grenzbereichs eingestellt wird, und ein Zeitpunkt, zu dem die Eingangsleistung des Motors (14) null wird, auf einen Ausgang des Grenzbereichs eingestellt wird, wobei zu dem Zeitpunkt des Schaltens von der Regeneration zu der Stromversorgung des Motors (14) ein Zeitpunkt, zu dem die Eingangsleistung des Motors (14) null wird, auf einen Eingang des Grenzbereichs eingestellt wird und ein Zeitpunkt, zu dem die Ausgangsleistung des Motors (14) null wird, auf einen Ausgang des Grenzbereichs eingestellt wird und innerhalb des Grenzbereichs erlaubt ist, dass die Eingangsleistung und die Ausgangsleistung des Motors in der Schalt-Schaltung (2) null sind.

**4.** Motorleistungsumsetzungsvorrichtung (10) nach Anspruch 1 oder 2, die ferner eine Schaltung zum Berechnen einer Ausgangsleistung (41) umfasst, die die Ausgangsleistung (Pout) des Motors berechnet,
wobei die Schaltung zum Berechnen der Ausgangsleistung (41):

eine Beschleunigung oder Drehbeschleunigung auf einen Geschwindigkeitsbefehl, der dem Motor in einem Zustand, in dem die Ausgangswelle (16) des Motors geöffnet ist oder eine Lastscheibe (72) an der Ausgangswelle (16) des Motors befestigt ist, und dem Rotor des Motors oder dem Motor (14) gegeben wird, anwendet und die Ausgangsleitung des Motors (14) gemäß einem beschleunigten/verlangsamten Drehmoment, das aufgrund einer Trägheit eines Rotors des Motors oder einer Trägheit des Rotors des Motors und der Lastscheibe (72) und einer Motordrehzahl, die eine Beschleunigung/Verlangsamung wiederholt, erzeugt wird, berechnet;
Messen des mittleren Motorwirkungsgrads ($\eta$av) durch die Divisionsschaltung (6) unter Verwendung der Ausgangsleistung des Motors (14); und
Messen des Motorverlustleistungsbetrags durch die Subtraktionsschaltung (7) unter Verwendung der Ausgangsleistung des Motors (14).

**5.** Motorleistungsumsetzungsschaltung (10) nach Anspruch 1 oder 2, die ferner umfasst:

dass eine Messbefehlsschaltung (69), die ein Motordrehmoment auf ein positives und negatives Nenndrehmoment durch den Motor (14) allein begrenzt oder eine Lastscheibe (72), die an einer Motorausgangswelle (16) befestigt ist, verwendet wird, mit zwei Geschwindigkeitsbefehlen eines Befehls einer positiven und einer negativen Geschwindigkeit versorgt wird, zu einem beliebigen der positiven oder negativen Geschwindigkeitsbefehle geschaltet wird, wenn eine Geschwindigkeit auf dem Weg, die an einen beliebigen der beiden Geschwindigkeitsbefehle des Befehls einer positiven und einer negativen Geschwindigkeit gerichtet ist, auf einer Umkehrrotationsseite detektiert wird und alternativ zu einem beliebigen des Befehls einer positiven und einer negativen Geschwindigkeit auf der Vorwärtsrotationsseite geschaltet wird, wenn eine Geschwindigkeit auf dem Weg der Umkehrrotationsseite detektiert wird; und
eine Schalt-Schaltung (2), die einen Bedienungsbefehl eines wiederholten Lastmusters, das durch eine Lastmaschine betrieben wird, die tatsächlich zu verwenden ist, eingibt, und den Geschwindigkeitsbefehl von der Messbefehlsschaltung (69) wechselt.

**6.** Motorleistungsumsetzungsvorrichtung (10) nach Anspruch 5,

wobei die detektierte Geschwindigkeit auf dem Weg, die auf die beiden Geschwindigkeitsbefehle des Befehls einer positiven und einer negativen Geschwindigkeit gerichtet ist, auf eine willkürliche Drehzahl und eine positive und eine negative Nenndrehzahl eingestellt wird und
wobei der mittlere Motorwirkungsgrad ($\eta$av) und der Motorverlustleistungsbetrag Werte sind, bei denen der Motor (14) ein Nenndrehmoment besitzt, und die Drehzahl einen Bereich von der willkürlichen Drehzahl, die Null enthält, zu der positiven und negativen Nenndrehzahl enthält.

**7.** Motorleistungsumsetzungssystem, das Folgendes umfasst:

eine Motorleistungsumsetzungsvorrichtung (10), die Leistung für einen Motor (14) umsetzt, nach Anspruch 1; und

eine Vorrichtung einer höheren Ebene (100), die einen Befehl an die Motorleistungsumsetzungsvorrichtung (10) ausgibt,

wobei die Motorleistungsumsetzungsvorrichtung (10) ferner enthält:

eine Verarbeitungseinheit zur Berechnung einer Ausgangsleistung (41), die eine Ausgangsleistung des Motors (14) berechnet;

eine Verarbeitungseinheit zur Berechnung einer Eingangsleistung (42), die eine Eingangsleistung des Motors berechnet; und

eine Verarbeitungseinheit zur Berechnung eines mittleren Wirkungsgrads/eines Verlustes (1),

wobei die Verarbeitungseinheit zur Berechnung eines mittleren Wirkungsgrads/eines Verlustes enthält:

die Schalt-Schaltung (2); und
die Absolutwertschaltung (4) und
wobei die Vorrichtung einer höheren Ebene (100) enthält:

die Integrationsverarbeitungseinheit (5);
die Divisionsverarbeitungseinheit (6); und
die Subtraktionsschaltung (7).

8. Motorleistungsumsetzungssystem, das umfasst:

eine Motorleistungsumsetzungsvorrichtung (10), die Leistung für einen Motor (14) umsetzt, nach Anspruch 1; und

eine Vorrichtung einer höheren Ebene (100), die einen Befehl an die Motorleistungsumsetzungsvorrichtung (10) ausgibt,

wobei die Motorleistungsumsetzungsvorrichtung (10) ferner enthält:

eine Verarbeitungseinheit zur Berechnung der Ausgangsleistung (41), die eine Ausgangsleistung des Motors (14) berechnet;

eine Verarbeitungseinheit zur Berechnung der Eingangsleistung (42), die eine Eingangsleistung des Motors berechnet; und

wobei die Vorrichtung einer höheren Ebene (100) eine Verarbeitungseinheit zur Berechnung eines mittleren Wirkungsgrads/eines Verlustes (1) enthält,

wobei die Verarbeitungseinheit zur Berechnung eines mittleren Wirkungsgrads/eines Verlustes enthält:

die Schalt-Schaltung (2);
die Absolutwertschaltung (4);
die Integrationsschaltung (5);
die Divisionsschaltung (6); und
die Subtraktionsschaltung (7).

## Revendications

1. Dispositif de conversion de puissance de moteur configuré pour convertir une puissance vers un moteur (14), et configuré en outre pour obtenir une efficacité moyenne de moteur ($\eta$av) et une quantité de puissance de perte de moteur (PTloss) d'un moteur (14), pour obtenir une valeur de détection de puissance électrique (Pin) du moteur en multipliant des valeurs de tension et de courant, et pour obtenir une valeur de détection de puissance mécanique (Pout) du moteur (14) en multipliant un couple nominal et une vitesse de rotation de l'arbre de sortie (16) du moteur (14) ;

caractérisé en ce qu'il comprend :

- un circuit de commutation (2) configuré, dans un mode d'alimentation dans lequel une direction de flux de puissance est depuis une source de puissance jusqu'à une charge, pour fixer la valeur de détection de puissance électrique (Pin) du moteur (14) en tant que puissance côté amont (PXin), et pour fixer la valeur de détection de puissance mécanique (Pout) du moteur (14) en tant que puissance côté aval (PXout), et, dans un mode de régénération dans lequel une direction de flux de puissance est depuis la charge jusqu'à la source de puissance, pour fixer la valeur de détection de puissance mécanique (Pout) en tant que puissance côté amont (PXin), et pour fixer la valeur de détection de puissance électrique (Pin) en tant que puissance côté aval (PXout) ;
- un circuit de valeur absolue (4) qui effectue un traitement de valeur absolue sur la puissance côté amont (PXin) et la puissance côté aval (PXout) ;
- un circuit d'intégration (5) qui intègre la puissance côté amont et la puissance côté aval soumises au traitement de valeur absolue (PWin, PWout) et qui sort les valeurs intégrées en tant que quantité de puissance côté amont (Pdin) et quantité de puissance côté aval (Pdout) ;
- un circuit de division (6) qui divise la quantité de puissance côté aval (Pdout) par la quantité de puissance côté amont (Pdin) pour obtenir l'efficacité moyenne de moteur ($\eta$av) ; et
- un circuit de soustraction (7) qui soustrait la quantité de puissance côté aval (Pdout) de la quantité de puissance côté amont (Pdin) pour obtenir la quantité de puissance de perte de moteur (PTloss).

2. Dispositif de conversion de puissance de moteur (10) selon la revendication 1, dans lequel le circuit de valeur absolue (4) effectue le traitement de valeur absolue uniquement pendant la régénération.

3. Dispositif de conversion de puissance de moteur (10) selon la revendication 1 ou 2, comprenant en outre un circuit de détection de zone d'alimentation/zone de régénération (22) qui sort un signal d'alimentation (MS) indiquant l'alimentation et un signal de régénération (GS) indiquant la régénération, qui sont entrés vers le circuit de commutation (2),
dans lequel, dans le circuit de détection de zone d'alimentation/zone de régénération (22), une région frontière au moment d'une commutation entre le signal d'alimentation et le signal de régénération est prévue, au moment d'une commutation depuis l'alimentation vers la régénération du moteur (14), un moment auquel la puissance de sortie du moteur (14) devient zéro est fixé à une entrée de la région frontière, et un moment auquel la puissance d'entrée du moteur (14) devient zéro est fixé à une sortie de la région frontière, au moment d'une commutation depuis la régénération vers l'alimentation du moteur (14), un moment auquel la puissance d'entrée du moteur (14) devient zéro est fixé à une entrée de la région frontière, et un moment auquel la puissance de sortie du moteur (14) devient zéro est fixé à une sortie de la région frontière, et à l'intérieur de la région frontière, la puissance d'entrée et la puissance de sortie du moteur sont autorisées à être zéro dans le circuit de commutation (2).

4. Dispositif de conversion de puissance de moteur (10) selon la revendication 1 ou 2, comprenant en outre un circuit de calcul de puissance de sortie (41) qui calcule la puissance de sortie (Pout) du moteur,
dans lequel le circuit de calcul de puissance de sortie (41) :

applique une accélération ou une accélération de rotation à un ordre de vitesse donné au moteur dans un état dans lequel l'arbre de sortie (16) du moteur est ouvert ou un disque de charge (72) est fixé à l'arbre de sortie (16) du moteur, et au rotor du moteur ou au moteur (14), et calcule la puissance de sortie du moteur (14) en accord avec un couple accéléré/décéléré généré en raison d'une inertie d'un rotor du moteur ou d'une inertie du rotor du moteur et du disque de charge (72) et d'une vitesse de rotation de moteur répétant une accélération/décélération ;
mesure l'efficacité moyenne de moteur ($\eta$av) via le circuit de division (6) en utilisant la puissance de sortie du moteur (14) ; et
mesure la quantité de puissance de perte de moteur via le circuit de soustraction (7) en utilisant la puissance de sortie du moteur (14).

5. Dispositif de conversion de puissance de moteur (10) selon la revendication 1 ou 2, comprenant en outre :

un circuit d'ordre de mesurage (69) qui limite un couple de moteur à un couple nominal positif et négatif via le moteur (14) seul ou un disque de charge (72) fixé à un arbre de sortie de moteur (16) est utilisé, est doté de deux ordres de vitesse parmi des ordres de vitesse positif et négatif, est commuté vers l'un quelconque des ordres de vitesse positif et négatif quand une vitesse sur la voie qui est dirigée vers l'un quelconque des deux de ordres vitesse parmi les ordres de vitesse positif et négatif sur le côté de rotation arrière est détectée, et est commuté alternativement vers l'un quelconque des ordres de vitesse positif et négatif sur le côté de rotation avant quand une vitesse sur la voie du côté de rotation arrière est détectée ; et
un circuit de commutation (2) qui entre un ordre d'actionnement d'un motif de charge répétitif actionné par une machine charge devant être utilisée réellement et qui commute l'ordre de vitesse depuis le circuit d'ordre de mesurage (69).

6. Dispositif de conversion de puissance de moteur (10) selon la revendication 5,

dans lequel la vitesse détectée sur la voie qui est dirigée vers les deux ordres de vitesse parmi les ordres de vitesse positif et négatif est fixée à une vitesse de rotation arbitraire et à des vitesses de rotation nominales positive et négative, et

dans lequel l'efficacité moyenne de moteur ($\eta$av) et la quantité de puissance de perte de moteur sont des valeurs dans lesquelles le moteur (14) a un couple nominal, et la vitesse de rotation inclut une plage allant de la vitesse de rotation arbitraire incluant zéro aux vitesses de rotation nominales positive et négative.

7. Système de conversion de puissance de moteur comprenant :

un dispositif de conversion de puissance de moteur (10) qui convertit une puissance vers moteur (14) selon la revendication 1 ; et

un dispositif de niveau supérieur (100) qui sort un ordre vers le dispositif de conversion de puissance de moteur (10),

dans lequel le dispositif de conversion de puissance de moteur (10) inclut en outre :

une unité de traitement de calcul de puissance de sortie (41) qui calcule une puissance de sortie du moteur (14) ;
une unité de traitement de calcul de puissance d'entrée (42) qui calcule une puissance d'entrée du moteur ; et
une unité de traitement de calcul d'efficacité/perte moyenne (1),

dans lequel l'unité de traitement de calcul d'efficacité/perte moyenne inclut :

le circuit de commutation (2) ;
le circuit de valeur absolue (4), et
dans lequel le dispositif de niveau supérieur (100) inclut :

l'unité de traitement d'intégration (5) ;
l'unité de traitement de division (6) ;
le circuit de soustraction (7).

8. Système de conversion de puissance de moteur comprenant :

un dispositif de conversion de puissance de moteur (10) qui convertit une puissance vers un moteur (14) selon la revendication 1 ; et

un dispositif de niveau supérieur (100) qui sort un ordre vers le dispositif de conversion de puissance de moteur (10),

dans lequel le dispositif de conversion de puissance de moteur (10) inclut en outre :

une unité de traitement de calcul de puissance de sortie (41) qui calcule une puissance de sortie du moteur ; et
une unité de traitement de calcul de puissance d'entrée (42) qui calcule une puissance d'entrée du moteur,
dans lequel le dispositif de niveau supérieur (100) inclut une unité de traitement de calcul d'efficacité/perte moyenne (1), et
dans lequel l'unité de traitement de calcul d'efficacité/perte moyenne (1) inclut :

le circuit de commutation (2) ;
le circuit de valeur absolue (4) ;
le circuit d'intégration (5) ;
le circuit de division (6) ; et
le circuit de soustraction (7).

F I G. 1

# F I G. 2

a) ROTATION SPEED N

② ③

FORWARD
ROTATION

④ ⑥

t

0

①

REVERSE
ROTATION

⑤

b) TORQUE T

+

②

③

⑥

0

①

⑤

④

−

FIRST
QUADRANT

THIRD
QUADRANT

FOURTH
QUADRANT

SECOND
QUADRANT

(POWERING) (REGENERATION) (POWERING) (REGENERATION)

c) INPUT POWER
Pin

OUTPUT POWER
Pout

+

Pin

0

Pout

t

−

F I G. 3

TORQUE
T

SECOND QUADRANT
$(N < 0 , T > 0)$

FIRST QUADRANT
$(N > 0 , T > 0)$

REGENERATION

POWERING

ROTATION SPEED
N

POWERING

REGENERATION

THIRD QUADRANT
$(N < 0 , T < 0)$

FOURTH QUADRANT
$(N > 0 , T < 0)$

F I G. 4

POWER SOURCE SIDE                             LOAD SIDE

UPSTREAM       FLOW OF POWER (POWERING)      DOWNSTREAM

DEVICE-SIDE INPUT POWER $P_{sin}$   INPUT POWER $P_{in}$   MOTOR LOSS $P_{loss}$   OUTPUT POWER $P_{out}$   LOAD-SIDE LOSS $P_{wloss}$   FINAL DEVICE OUTPUT $P_{mout}$

F I G. 5

POWER SOURCE SIDE                             LOAD SIDE

DOWNSTREAM       FLOW OF POWER (REGENERATION)      UPSTREAM

DEVICE-SIDE INPUT POWER $P_{sin}$   INPUT POWER $P_{in}$   MOTOR LOSS $P_{loss}$   OUTPUT POWER $P_{out}$   LOAD-SIDE LOSS $P_{wloss}$   FINAL DEVICE OUTPUT $P_{mout}$

EP 3 576 292 B1

F I G. 7

F I G. 8

# FIG. 9

AT TIME OF SWITCHING FROM POWERING TO REGENERATION

TIME POINT C1 WHERE Pout BECOMES ZERO PRIOR TO Pin, THAT IS, DENOMINATOR OF EFFICIENCY $\eta$ m DURING POWERING WHICH BECOMES ZERO ($\eta$ m →∞) IS SET TO ENTRANCE OF BOUNDARY REGION; AND TIME POINT C2 WHERE NUMERATOR (Pin) OF REGENERATION SIDE LEAVES ZERO IS SET TO EXIT

INPUT POWER Pin
OUTPUT POWER Pout
Pin
Pout
C1
C2
TIME t

POWERING SIGNAL MS
REGENERATION SIGNAL GS
H
L
L
H
TIME t
TIME t

POWERING — REGENERATION —

BOUNDARY REGION

# FIG. 10

AT TIME OF SWITCHING FROM REGENERATION TO POWERING

INPUT POWER Pin
OUTPUT POWER Pout
C1
C2
Pin
Pout
TIME t

TIME POINT C1 WHERE Pin BECOMES ZERO PRIOR TO Pout, THAT IS, DENOMINATOR OF EFFICIENCY $\eta$ g DURING REGENERATION WHICH BECOMES ZERO ($\eta$ g →∞) IS SET TO ENTRANCE OF BOUNDARY REGION; AND TIME POINT C2 WHERE NUMERATOR (Pout) OF POWERING SIDE LEAVES ZERO IS SET TO EXIT

POWERING SIGNAL MS
REGENERATION SIGNAL GS
L
H
H
L
TIME t
TIME t

REGENERATION — POWERING —

BOUNDARY REGION

# F I G. 1 1

a) MEASUREMENT START/STOP
S/H SIGNAL

FORWARD ROTATION

b) ROTATION SPEED N
TORQUE T

N

T

REVERSE ROTATION

c) INPUT POWER
Pin
OUTPUT POWER
Pout

Pin

Pout

d) "H" DURING POWERING
MS SIGNAL

POWERING          POWERING

e) "H" DURING REGENERATION
GS SIGNAL

REGENE-
RATION

REGENE-
RATION

f) UPSTREAM-SIDE POWER AFTER
OUTPUT OF SYNCHRONIZED
SWITCHING CIRCUIT
PXin

g) DOWNSTREAM-SIDE POWER AFTER
OUTPUT OF SYNCHRONIZED
SWITCHING CIRCUIT
PXout

h) UPSTREAM-SIDE POWER AFTER
OUTPUT OF ABSOLUTE VALUE
CIRCUIT
PWin

i) DOWNSTREAM-SIDE POWER AFTER
OUTPUT OF ABSOLUTE VALUE
PWout

33

F I G . 1 2

EP 3 576 292 B1

34

F I G. 1 3

EP 3 576 292 B1

# F I G . 1 5

F I G . 1 6

+T₁₀₀ : RATED TORQUE OF PLUS SIDE
−T₁₀₀ : RATED TORQUE OF MINUS SIDE
+N₁₀₀ : RATED ROTATION SPEED OF PLUS SIDE
−N₁₀₀ : RATED ROTATION SPEED OF MINUS SIDE

F I G . 1 7

F I G . 1 8

EP 3 576 292 B1

FIG.19

F I G. 2 0

F I G. 2 1

FIRST QUADRANT (N > 0 , T > 0)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012014649 A
- EP 3107204 A1
- US 2016020721 A1
- US 2007056185 A1